# EUROPEAN PATENT APPLICATION

(11) **EP 4 336 575 A1**
(43) Date of publication of application: **13.03.2024**
(21) Application number: 23188789.4
(22) Date of filing: 31.07.2023
(51) Int. Cl.: H01L 33/38, H01L 33/40, H01L 33/46

(54) **LIGHT-EMITTING ELEMENT AND DISPLAY DEVICE INCLUDING THE SAME**

(30) Priority: 07.09.2022 KR 20220113534
(71) Applicant: Samsung Display Co., Ltd., Yongin-si, Gyeonggi-do 17113 (KR)
(72) Inventor: HAM, Ji Hyun, 17113 Yongin-si (KR); AN, Moon Jung, 17113 Yongin-si (KR); PARK, Jin Seok, 17113 Yongin-si (KR); LEE, Hee Keun, 17113 Yongin-si (KR); JO, Sung Chan, 17113 Yongin-si (KR); HAN, Sang Wook, 17113 Yongin-si (KR)
(74) Representative: Taor, Simon Edward William

(57) **Abstract**

A light-emitting element includes a first semiconductor layer, a light-emitting layer disposed on the first semiconductor layer, a second semiconductor layer disposed on the light-emitting layer, a device electrode layer disposed on the second semiconductor layer, a reflective electrode layer disposed on the device electrode layer, an insulating film surrounding a side surface of the light-emitting layer, a side surface of the second semiconductor layer, and a side surface of the device electrode layer, and a reflective layer surrounding a side surface of the insulating film, wherein the side surface of the device electrode layer is aligned with a side surface of the reflective electrode layer.

## Description

### BACKGROUND

### 1. Technical Field

Embodiments relate to a light-emitting element and a display device including the light-emitting element.

### 2. Description of the Related Art

Display devices have been more important with developments in multimedia technology. Various display devices such as an organic light-emitting diode (OLED) display device, a liquid crystal display (LCD) device, and the like have been used.

Typically, a display device includes a display panel such as an organic light-emitting display panel or an LCD panel. A light-emitting display panel may include light-emitting elements such as light-emitting diodes (LEDs). Examples of the LEDs include organic LEDs (OLEDs) formed of an organic material as a light-emitting material and inorganic LEDs formed of an inorganic material as a light-emitting material.

### SUMMARY

Embodiments provide a light-emitting element capable of improving optical efficiency.

Embodiments also provide a display device including a light-emitting element capable of improving optical efficiency.

However, embodiments of the disclosure are not limited to those set forth herein.
The above and other embodiments will become more apparent to one of ordinary skill in the art to which the disclosure pertains by referencing the detailed description of the disclosure given below.

In an embodiment, a light-emitting element may include a first semiconductor layer, a light-emitting layer disposed on the first semiconductor layer, a second semiconductor layer disposed on the light-emitting layer, a device electrode layer disposed on the second semiconductor layer, a reflective electrode layer disposed on the device electrode layer, an insulating film surrounding a side surface of the light-emitting layer, a side surface of the second semiconductor layer, and a side surface of the device electrode layer, and a reflective layer surrounding a side surface of the insulating film, wherein the side surface of the device electrode layer may be aligned with a side surface of the reflective electrode layer.

In an embodiment, an upper surface of the device electrode layer may be aligned with an upper surface of the insulating film and an upper surface of the reflective layer.

In an embodiment, the insulating film may further surround a side surface of the reflective electrode layer, and an upper surface of the reflective electrode layer may be aligned with an upper surface of the insulating film and an upper surface of the reflective layer.

In an embodiment, the insulating film may further surround a side surface of the reflective electrode layer, and a lower surface of the first semiconductor layer may be aligned with a lower surface of the insulating film and a lower surface of the reflective layer.

In an embodiment, the insulating film may be formed as a multilayer film.

In an embodiment, the reflective layer may include first layers and second layers, which include an insulating material having a different refractive index, and the first layers and the second layers may be alternately arranged.

In an embodiment, the reflective layer may be formed as a single-layer film or a multilayer film including a metal.

In an embodiment, a light-emitting element may include a first semiconductor layer, a light-emitting layer disposed on the first semiconductor layer, a second semiconductor layer disposed on the light-emitting layer, a device electrode layer disposed on the second semiconductor layer, an insulating film surrounding a side surface of the light-emitting layer, a side surface of the second semiconductor layer, and a side surface of the device electrode layer, and an insulating film surrounding a side surface of the first semiconductor layer, a side surface of the light-emitting layer, a side surface of the second semiconductor layer, and a side surface of the device electrode layer, wherein the first semiconductor layer may include a first portion spaced apart from the light-emitting layer, and a second portion surrounded by the insulating film and adjacent to the light-emitting layer, and a width of the second portion of the first semiconductor layer may be less than a width of the first portion of the first semiconductor layer.

In an embodiment, a width of the light-emitting layer, a width of the second semiconductor layer, and a width of the device electrode layer may be less than the width of the first portion of the first semiconductor layer.

In an embodiment, a side surface of the insulating film may be aligned with a side surface of the first portion of the first semiconductor layer.

In an embodiment, the light-emitting element may further include a reflective layer surrounding a side surface of the insulating film, wherein a side surface of the reflective layer may be aligned with a side surface of the first portion of the first semiconductor layer.

In an embodiment, the light-emitting element may further include a metal layer surrounding the side surface of the insulating film and a side surfaces of the first portion of the first semiconductor layer.

In an embodiment, the light-emitting element may further include a metal layer surrounding the side surface of the first portion of the first semiconductor layer.

In an embodiment, the metal layer may further surround a side surface of the insulating film.

In an embodiment, the insulating film may cover a portion of an upper surface of the device electrode layer.

In an embodiment, the light-emitting element may further include a reflective layer surrounding a side surface of the insulating film, wherein the reflective layer may overlap an upper surface of the device electrode layer in a thickness direction.

In an embodiment, the light-emitting element may further include a metal layer surrounding a side surface of the first portion of the first semiconductor layer, wherein the metal layer may not be in contact with a side surface of the insulating film.

In an embodiment, the light-emitting element may further include a reflective layer surrounding the side surface of the insulating film, wherein the side surface of the reflective layer may be aligned with the side surface of the first portion of the first semiconductor layer.

In an embodiment, the light-emitting element may further include a metal layer disposed on the insulating film and the device electrode layer, wherein the metal layer may surround the side surface of the light-emitting layer and may be disposed on an outer side surface of the insulating film.

In an embodiment, the light-emitting element may further include a reflective layer disposed between the insulating film and the metal layer, wherein the reflective layer surrounds a side surface of the insulating film, and the metal layer may surround the side surface of the light-emitting layer and may be on the outer side surface of the reflective layer.

In an embodiment, the light-emitting element may further include a reflective layer surrounding a side surface of the insulating film and a side surface of the second portion of the first semiconductor layer, wherein the reflective layer may be a distributed Bragg reflector (DBR).

In an embodiment, a display device may include a substrate, pixel electrodes disposed on the substrate, light-emitting elements disposed on the pixel electrodes, an organic layer disposed on the pixel electrodes, between the light-emitting elements, and a common electrode disposed on the organic layer and the light-emitting elements, wherein each of the light-emitting elements may include a first semiconductor layer, a light-emitting layer disposed on the first semiconductor layer, a second semiconductor layer disposed on the light-emitting layer, a device electrode layer disposed on the second semiconductor layer, a reflective electrode layer disposed on the device electrode layer, a first insulating film surrounding a side surface of the light-emitting layer, a side surface of the second semiconductor layer, and a side surface of the device electrode layer, and a reflective layer surrounding a side surface of the first insulating film, and the side surface of the device electrode layer may be aligned with a side surface of the reflective electrode layer.

In an embodiment, each of the light-emitting elements may further include a connecting electrode disposed on the reflective electrode layer, the connecting electrode may be connected to each of the pixel electrodes, and the first semiconductor layer may be connected to the common electrode.

In an embodiment, the display device may further include a second insulating film surrounding an outer surface of the reflective layer, wherein the reflective layer may include a metal.

In an embodiment, the second insulating film may be in contact with the pixel electrode and the connecting electrode.

In an embodiment, the display device may further include a third insulating film disposed between the reflective layer and the common electrode, wherein the third insulating film may be in contact with the reflective layer and may cover the reflective layer.

In an embodiment, the second insulating film may be in contact with the pixel electrode, and a gap may be disposed between the connecting electrode and the second insulating film.

In an embodiment, the organic layer may include a first organic layer disposed on the pixel electrode, and a second organic layer disposed on the first organic layer, and the reflective layer may be disposed on the first organic layer, may surround the side surface of the light-emitting layer, and may be disposed on an outer side surface of the first insulating film.

In an embodiment, the common electrode surrounds the side surface of the first insulating film and may be in contact with the side surface of the first insulating film.

According to the aforementioned and other embodiments of the disclosure, as a multilayer insulating film surrounds a light-emitting layer of a light-emitting element, the quantum efficiency and the momentary afterimage of the light-emitting element may be improved.

Also, as a reflective layer surrounds the insulating film of the light-emitting element, the light output efficiency of the light-emitting element may be improved by reflecting light emitted from the light-emitting layer.

It should be noted that the effects of the disclosure are not limited to those described above, and other effects of the disclosure will be apparent from the following description.

### BRIEF DESCRIPTION OF THE DRAWINGS

The above and other aspects and features of the disclosure will become more apparent by describing in detail embodiments thereof with reference to the attached drawings, in which:
FIG. 1 is a schematic plan view of a display device according to an embodiment;
FIG. 2 is a schematic layout view of the circuitry of a display substrate of the display device of FIG. 1;
FIG. 3 is a schematic diagram of an equivalent circuit of a pixel of the display device of FIG. 1;
FIG. 4 is a schematic diagram of an equivalent circuit of a pixel of a display device according to another embodiment;
FIG. 5 is a schematic diagram of an equivalent circuit of a pixel of a display device according to another embodiment;
FIG. 6 is a schematic cross-sectional view of the display device of FIG. 1;
FIG. 7 is a schematic plan view illustrating emission areas of the display device of FIG. 1;
FIG. 8 is a schematic cross-sectional view of a light-emitting element according to an embodiment;
FIG. 9 is a graph showing the rate of luminance change versus the duration of driving of light-emitting elements;
FIG. 10 is a schematic enlarged cross-sectional view of an area A of FIG. 8;
FIG. 11 is a graph showing the variation of the reflectance of each wavelength band of light versus the number of layers that are alternately stacked in a reflective layer;
FIG. 12 is a graph showing the variation of the reflectance of light of a wavelength of about 460 nm versus the number of layers that are alternately stacked in a reflective layer;
FIG. 13 is a schematic enlarged cross-sectional view of a light-emitting element of FIG. 6;
FIG. 14 is a schematic cross-sectional view of a light-emitting element according to another embodiment;
FIG. 15 is a schematic cross-sectional view of a light-emitting element according to another embodiment;
FIG. 16 is a schematic plan view illustrating a first semiconductor layer of the light-emitting element of FIG. 15;
FIG. 17 is a schematic cross-sectional view of a light-emitting element according to another embodiment;
FIGS. 18 and 19 are schematic cross-sectional views of light-emitting elements according to other embodiments;
FIGS. 20 and 21 are schematic cross-sectional views of light-emitting elements according to other embodiments;
FIGS. 22 and 23 are schematic cross-sectional views of light-emitting elements according to other embodiments;
FIGS. 24 and 25 are schematic cross-sectional views of light-emitting elements according to other embodiments;
FIGS. 26 and 27 are schematic cross-sectional views of light-emitting elements according to other embodiments;
FIG. 28 is a schematic cross-sectional view of a light-emitting element according to another embodiment;
FIG. 29 is a schematic cross-sectional view of a display device according to another embodiment;
FIG. 30 is a schematic cross-sectional view of a display device according to another embodiment;
FIG. 31 is a schematic cross-sectional view of a display device according to another embodiment;
FIG. 32 is a schematic cross-sectional view of a display device according to another embodiment;
FIG. 33 is a schematic cross-sectional view of a display device according to another embodiment;
FIG. 34 is a schematic cross-sectional view of a display device according to another embodiment;
FIG. 35 is a flowchart illustrating a method of manufacturing a display device according to an embodiment; and
FIGS. 36 through 52 are schematic cross-sectional views illustrating the method of FIG. 35.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order.
Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Embodiments will hereinafter be described with reference to the attached drawings.

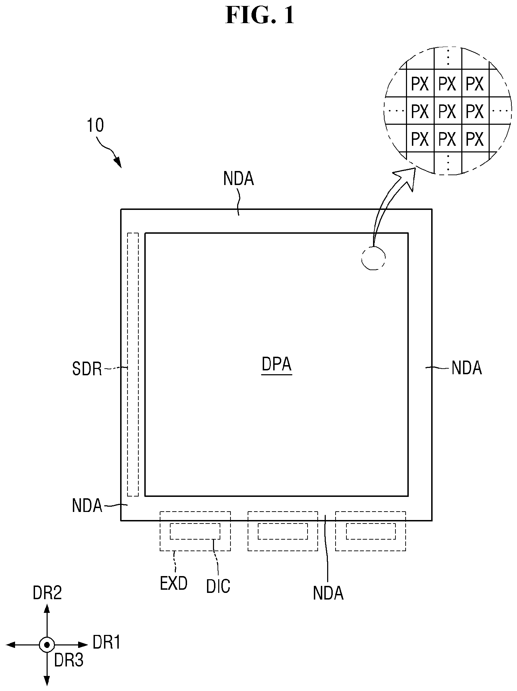

FIG. 1 is a schematic plan view of a display device according to an embodiment.

Referring to FIG. 1, a display device 10 may be applicable to smartphones, mobile phones, tablet personal computers (PCs), personal digital assistants (PDAs), portable multimedia players (PMPs), televisions (TVs), game consoles, wristwatch-type electronic devices, head-mounted displays, PC monitors, notebook computers, car navigation systems, car dashboards, digital cameras, camcorders, electric billboards, various medical devices, various inspection devices, home appliances (such as refrigerators and washing machines), and Internet-of-Things (IoT) devices. The display device 10 will hereinafter be described as being, for example, a TV having a high or ultrahigh resolution such as HD, UHD, 4K, or 8K.

The display device 10 may be classified according to display methods. For example, the display device 10 may be an organic light-emitting diode (OLED) display device, an inorganic electro-luminescence (EL) display device, a quantum-dot light-emitting display (QED) device, a micro-light-emitting diode (microLED) display device, a nano-light-emitting diode (nanoLED) display device, a plasma display device (PDP), a field emission display (FED) device, a cathode-ray tube (CRT) device, a liquid crystal display (LCD) device, or an electrophoretic display (EPD) device. The display device 10 will hereinafter be described as being, for example, an OLED display device, and an OLED display device will hereinafter be simply referred to as a display device, unless specified otherwise. However, the display device 10 of embodiments is not limited to an OLED display device, and various other display devices may also be applicable to the display device 10.

A first direction DR1 refers to the horizontal direction of the display device 10, a second direction DR2 refers to the vertical direction of the display device 10, and a third direction DR3 refers to the thickness direction of the display device 10. The terms "left," "right," "upper," and "lower," as used herein, refer to their respective directions as viewed from above the display device 10. For example, the term "right side" refers to a side in the first direction DR1, the term "left side" refers to the other side in the first direction DR1, the term "upper side" refers to a first side in the second direction DR2, and the term "lower side" refers to a second side in the second direction DR2. The term "top" (or "upper') refers to a side in the third direction DR3, and the term "bottom" (or "lower") refers to another side in the third direction DR3.

The display device 10 may have, for example, a square shape, in a plan view. In a case where the display device 10 is a TV, the display device 10 may have a rectangular shape whose long sides are aligned in the horizontal direction of the display device 10, but embodiments are not limited thereto. In another example, the display device 10 may have a rectangular shape whose long sides are aligned in the vertical direction of the display device 10 or may be rotatably installed such that the long sides of the display device 10 may be variably aligned in the horizontal or vertical direction of the display device 10. In another example, the display device 10 may have a circular or elliptical shape.

The display device 10 may include a display area DPA and a non-display area NDA. The display area DPA may be an active area where the display of an image is performed. The display area DPA may have a similar shape to the display device 10, for example, a square shape, in a plan view, but embodiments are not limited thereto.

The display area DPA may include pixels PX. The pixels PX may be arranged in row and column directions. The pixels PX may have a rectangular or square shape in a plan view, but embodiments are not limited thereto. In another example, the pixels PX may have a rhombus shape having sides inclined with respect to the sides of the display device 10.
The pixels PX may include pixels PX of various colors. For example, the pixels PX may include first-color pixels PX (e.g., red pixels PX), second-color pixels PX (e.g., green pixels PX), and third-color pixels PX (e.g., blue pixels PX), but embodiments are not limited thereto. The pixels PX of the various colors may be alternately arranged in a stripe or Pentile^{™} type.

The non-display area NDA may be disposed around the display area DPA. The non-display area NDA may surround the entire display area DPA or portion of the display area DPA. The display area DPA may have a square shape, and the non-display area NDA may be disposed adjacent to the four sides of the display area DPA. The non-display area NDA may form the bezel of the display device 10.

Driving circuits or driving elements for driving the display area DPA may be disposed in the non-display area NDA. In portion of the non-display area NDA adjacent to a first side (or the lower side) of the display device 10, a pad unit may be provided on a display substrate of the display device 10, and an external device EXD may be mounted on pad electrodes in the pad unit. Examples of the external device EXD may include a connecting film, a printed circuit board (PCB), a driver integrated chip DIC, a connector, and a wire connecting film. In portion of the non-display area NDA adjacent to a second side (or the left side) of the display device 10, a scan driving unit SDR, which is formed (e.g., directly formed) on the display substrate of the display device 10, may be disposed.

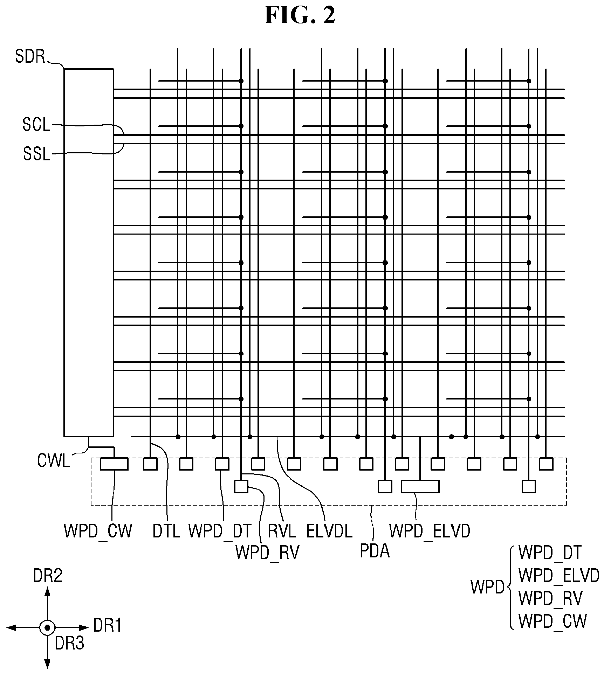

FIG. 2 is a schematic layout view of the circuitry of the display substrate of the display device of FIG. 1.

Referring to FIG. 2, lines are disposed on a substrate. The lines may include scan lines SCL, sensing signal lines SSL, data lines DTL, reference voltage lines RVL, and a first power supply line ELVDL.

The scan lines SCL and the sensing signal lines SSL may extend in the first direction DR1. The scan lines SCL and the sensing signal lines SSL may be connected to a scan driving unit SDR. The scan driving unit SDR may include a scan driving circuit. The scan driving unit SDR may be disposed in the non-display area NDA, on a side of the display area DA, but embodiments are not limited thereto. In another example, the scan driving unit SDR may be disposed in the non-display area NDA, on both sides of the display area DA. The scan driving unit SDR may be connected to a signal connecting line CWL, and at least one end portion of the signal connecting line CWL may form a pad WPD_CW in the non-display area NDA and may be connected to the external device EXD of FIG. 1.

The data lines DTL and the reference voltage lines RVL may extend in the second direction DR2, which intersects the first direction DR1. The first power supply line ELVDL may include parts extending in the second direction DR2. The first power supply line ELVDL may further include parts extending in the first direction DR1. The first power supply line ELVDL may have a mesh structure, but embodiments are not limited thereto.

Wire pads WPD may be disposed at at least one end portion of each of the data lines DTL, the reference voltage lines RVL, and the first power supply line ELVDL. The wire pads WPD may be disposed in a pad unit PDA of the non-display area NDA. Wire pads WPD_DT (hereinafter, the data wire pads WPD_DT) of the data lines DTL, wire pads WPD_RV (hereinafter, the reference voltage pads WPD_RV) of the reference voltage lines RVL, and a wire pad WPD_ELVD (hereinafter, the first power supply pad WPD_ELVD) of the first power supply line ELVDL May be disposed in the pad unit PDA of the non-display area NDA. In another example, the data pads WPD_DT, the reference voltage pads WPD_RV, and the first power supply pad WPD_ELVD may be disposed in different parts of the non-display area NDA. As already mentioned above, the external device EXD of FIG. 1 may be mounted on the wire pads WPD. The external device EXD may be mounted on the wire pads WPD via anisotropic conductive films (ACFs) or ultrasonic bonding.

Each pixel PX on the display substrate may include a pixel driving circuit. The above-described lines may apply driving signals to the pixel driving circuit, passing by or through each pixel PX. The pixel driving circuit may include transistors and a capacitor. The numbers of transistors and capacitors included in the pixel driving circuit may vary. For example, the pixel driving circuit will hereinafter be described as having a "3T-1C" structure including three transistors and one capacitor, but embodiments are not limited thereto. In another example, various other structures such as a "2T-1C", "7T-1C", or "6T-1C" structure may also be applicable to the pixel driving circuit.

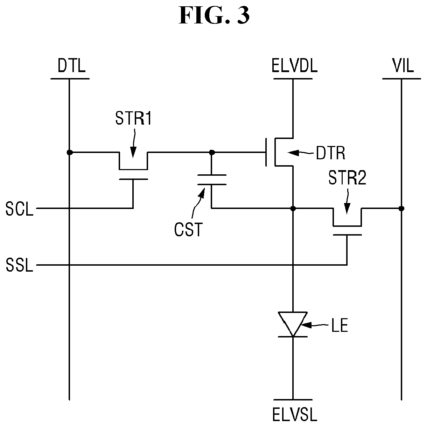

FIG. 3 is a schematic diagram of an equivalent circuit of a pixel of the display device of FIG. 1.

Referring to FIG. 3, a pixel PX may include a light-emitting element LE, three transistors, e.g., a driving transistor DTR, a first transistor STR1, and a second transistor STR2, and a capacitor CST.

The light-emitting element LE may emit light in accordance with a current applied thereto through the driving transistor DTR. The light-emitting element LE may be implemented as an inorganic light-emitting diode (LED), an OLED, a microLED, or a nanoLED.

A first electrode (or an anode) of the light-emitting element LE may be connected to a source electrode of the driving transistor DTR, a second electrode (or a cathode) of the light-emitting element LE may be connected to a second power supply line ELVSL, to which a low-potential voltage (or a second power supply voltage) is supplied. The second power supply voltage may be lower than a high-potential voltage (or a first power supply voltage) supplied to the first power supply line ELVDL.

The driving transistor DTR may control a current flowing from the first power supply line ELVDL into the light-emitting element LE, in accordance with the difference in voltage between a gate electrode and the source electrode thereof. The gate electrode of the driving transistor DTR may be connected to a first electrode of the first transistor ST1, the source electrode of the driving transistor DTR may be connected to the first electrode of the light-emitting element LE, and a drain electrode of the driving transistor DTR may be connected to the first power supply line ELVDL, to which the first power supply voltage is supplied.

The first transistor STR1 may be turned on by a scan signal from a scan line SCL to connect a data line DTL and the gate electrode of the driving transistor DTR. The gate electrode of the first transistor STR1 may be connected to the scan line SCL, the first electrode of the first transistor STR1 may be connected to the gate electrode of the driving transistor DTR, and a second electrode of the first transistor STR1 may be connected to a data line DTL.

The second transistor STR2 may be turned on by a sensing signal from a sensing signal line SSL to connect an initialization voltage line VIL and the source electrode of the driving transistor DTR. The gate electrode of the second transistor STR2 may be connected to the sensing signal line SSL, a first electrode of the second transistor STR2 may be connected to the initialization voltage line VIL, and a second electrode of the second transistor STR2 may be connected to the source electrode of the driving transistor DTR.

The first electrodes of the first and second transistors STR1 and STR2 may be source electrodes, and the second electrodes of the first and second transistors STR1 and STR2 may be drain electrodes. In another example, the first electrodes of the first and second transistors STR1 and STR2 may be drain electrodes, and the second electrodes of the first and second transistors STR1 and STR2 may be source electrodes.

The capacitor CST may be formed between the gate and source electrodes of the driving transistor DTR. The capacitor CST stores a differential voltage corresponding to the difference in voltage between the gate and source electrodes of the driving transistor DTR.

The driving transistor DTR and the first and second transistors STR1 and STR2 may be formed as thin-film transistors (TFTs). FIG. 3 illustrates that the driving transistor DTR and the first and second transistors STR1 and STR2 are N-type metal-oxide semiconductor field-effect transistors (MOSFETs), but embodiments are not limited thereto. In another example, the driving transistor DTR and the first and second transistors STR1 and STR2 may be P-type MOSFETs. In another example, some of the driving transistor DTR and the first and second transistors STR1 and STR2 may be P-type MOSFETs, and the other transistors may be P-type MOSFETs.

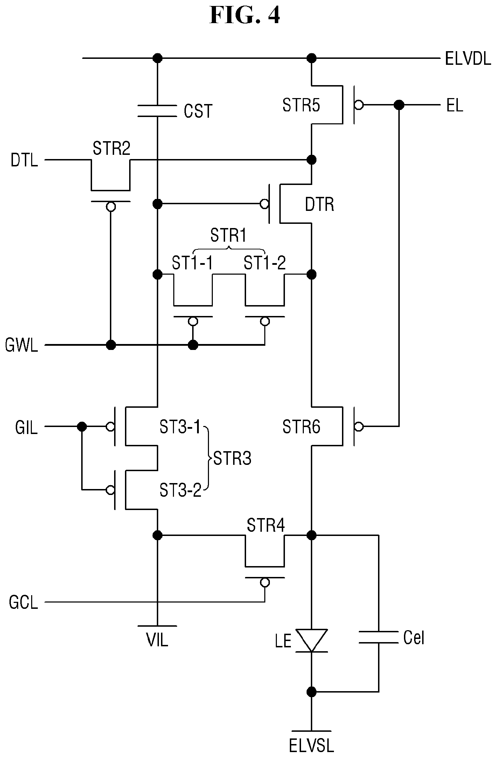

FIG. 4 is a schematic diagram of an equivalent circuit of a pixel of a display device according to another embodiment.

Referring to FIG. 4, a first electrode of a light-emitting element LE may be connected to a first electrode of a fourth transistor STR4 and a second electrode of a sixth transistor STR6, and a second electrode of the light-emitting element LE may be connected to a second power supply line ELVSL. A parasitic capacitor Cel may be formed between the first and second electrodes of the light-emitting element LE.

A pixel PX may include a driving transistor DTR, switching elements, and a capacitor CST. The switching elements include a first transistor STR1, a second transistor STR2, a third transistor STR3, the fourth transistor STR4, a fifth transistor STR5, and the sixth transistor STR6.

The driving transistor DTR may include a gate electrode, a first electrode, and a second electrode. The driving transistor DTR may control a drain-source current Ids (hereinafter, the driving current Ids) flowing between the first and second electrodes thereof.

The capacitor CST may be formed between the second electrode of the driving transistor DTR and a second power supply line ELVSL. A first electrode of the capacitor CST may be connected to the second electrode of the driving transistor DTR, and a second electrode of the capacitor CST may be connected to the second power supply line ELVSL.

In case that the first electrodes of the first through sixth transistors STR1 through STR6 and the first electrode of the driving transistor DTR are source electrodes, the second electrodes of the first through sixth transistors STR1 through STR6 and the second electrode of the driving transistor DTR may be drain electrodes. In another example, in case that the first electrodes of the first through sixth transistors STR1 through STR6 and the first electrode of the driving transistor DTR are drain electrodes, the second electrodes of the first through sixth transistors STR1 through STR6 and the second electrode of the driving transistor DTR may be source electrodes.

Active layers of the first through sixth transistors STR1 through STR6 and an active layer of the driving transistor DTR may be formed of one of polysilicon, amorphous silicon, and an oxide semiconductor. For example, the active layers of the first through sixth transistors STR1 through STR6 and the active layer of the driving transistor DTR may be formed of polysilicon by a low-temperature polysilicon (LTPS) process.

FIG. 4 illustrates that the first through sixth transistors STR1 through STR6 and the driving transistor DTR are formed as P-type MOSFETs, but embodiments are not limited thereto. In another example, the first through sixth transistors STR1 through STR6 and the driving transistor DTR may be formed as N-type MOSFETs. For example, the first transistor STR1 may include a first-first transistor ST1-1 and a first-second transistor ST1-2, which are connected to each other in series and are formed as P-type MOSFETs. For example, the third transistor STR3 may include a third-first transistor ST3-1 and a third-second transistor ST3-2, which are connected to each other in series and are formed as P-type MOSFETs.

A first power supply voltage from a first power supply line ELVDL, a second power supply voltage from the second power supply line ELVSL, and a third power supply voltage (or initialization voltage) from a third power supply line (or initialization voltage line) VIL may be set in consideration of the characteristics of the driving transistor DTR and the characteristics of the light-emitting element LE.

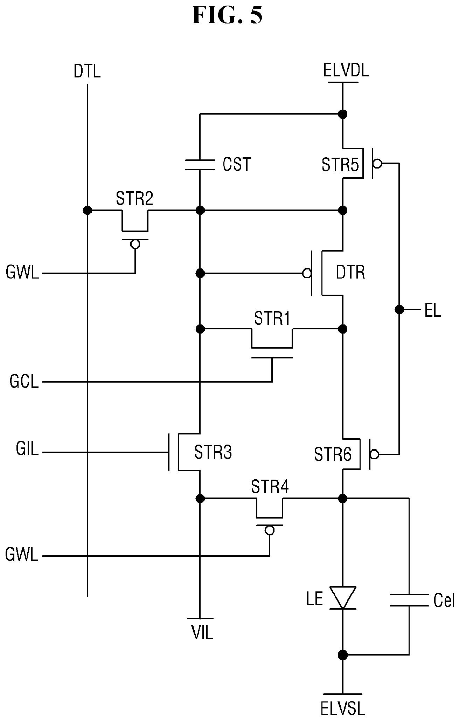

FIG. 5 is a schematic diagram of an equivalent circuit of a pixel of a display device according to another embodiment.

The embodiment of FIG. 5 differs from the embodiment of FIG. 4 in that a driving transistor DTR and second, fourth, fifth, and sixth transistors STR2, STR4, STR5, and STR6 are formed as P-type MOSFETs and first and third transistors STR1 and STR3 are formed as N-type MOSFETs.

Referring to FIG. 5, active layers of P-type MOSFETs, e.g., an active layer of the driving transistor DTR and active layers of the second, fourth, fifth, and sixth transistors STR2, STR4, STR5, and STR6, may be formed of polysilicon, and active layers of N-type MOSFETs, e.g., active layers of the first and third transistors STR1 and STR3, may be formed of an oxide semiconductor.

The embodiment of FIG. 5 also differs from the embodiment of FIG. 4 in that gate electrodes of the second and fourth transistors STR2 and STR4 are connected to a write scan line GWL and a gate electrode of the first transistor ST1 is connected to a control scan line GCL. As the first and third transistors STR1 and STR3 are formed as N-type MOSFETs, a scan signal having a gate-high voltage may be applied to the control scan line GCL and an initialization scan line GIL. As the second, fourth, fifth, and sixth transistors STR2, STR4, STR5, and STR6 are formed as P-type MOSFETs, a scan signal having a gate-low voltage may be applied to the write scan line GWL and an emission line EL.

Embodiments are not limited to the equivalent circuit of FIGS. 3 through 5, and various other circuit configurations that are available to one of ordinary skill in the art, to which the disclosure pertains, may also be implemented.

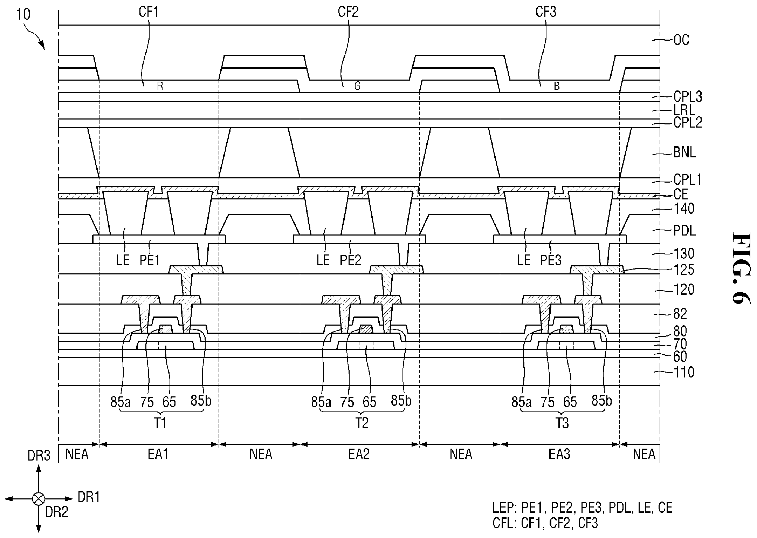

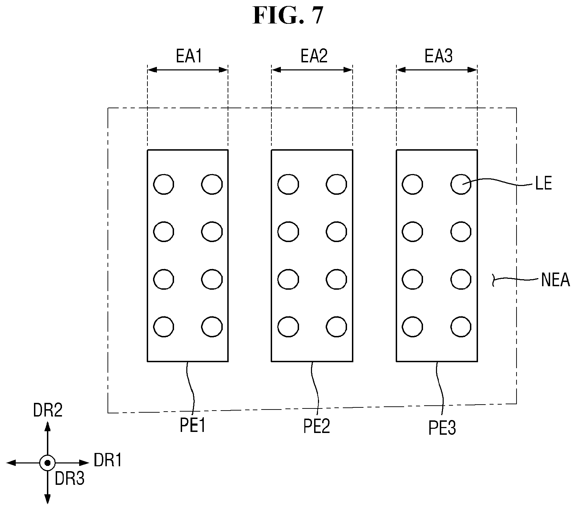

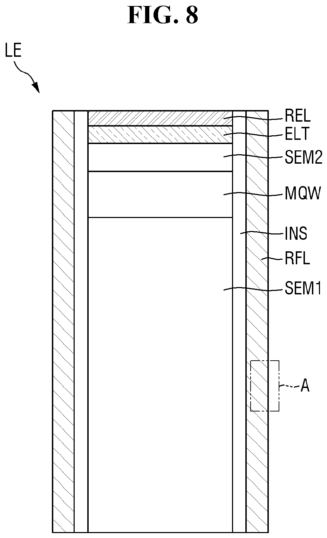

FIG. 6 is a schematic cross-sectional view of the display device of FIG. 1. FIG. 7 is a schematic plan view illustrating emission areas of the display device of FIG. 1. FIG. 8 is a schematic cross-sectional view of a light-emitting element according to an embodiment.

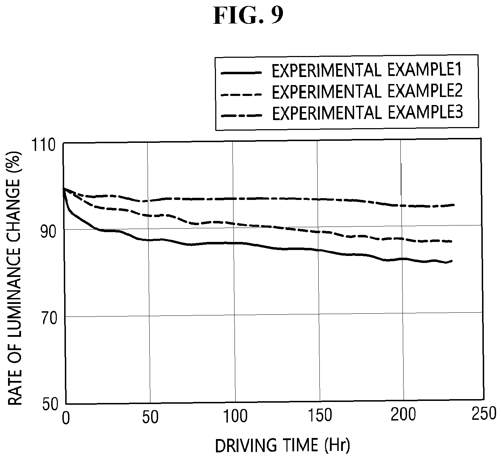

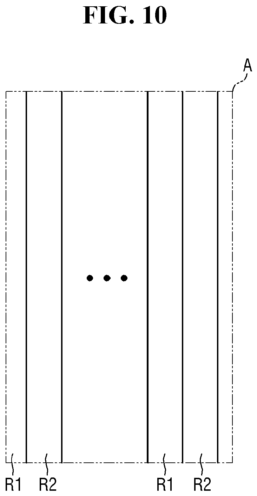

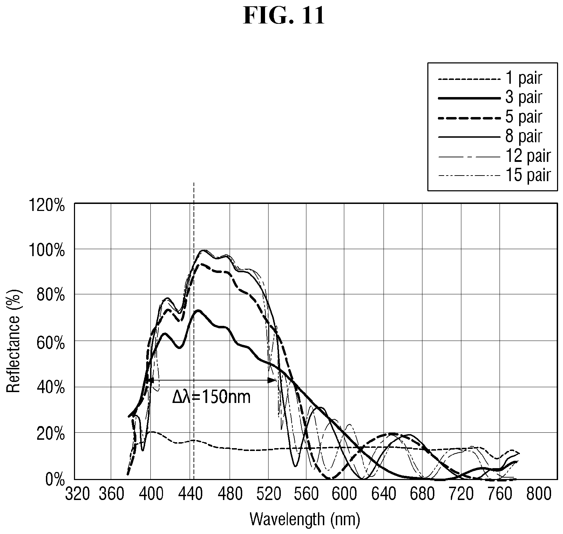

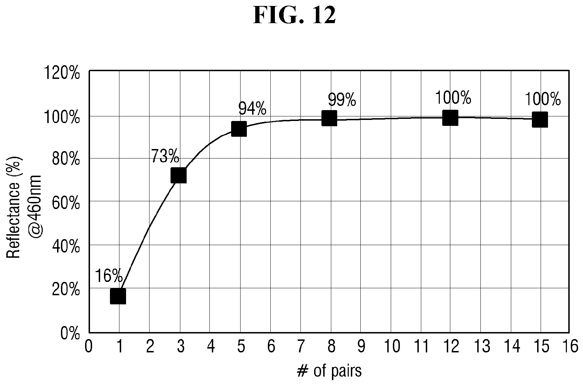

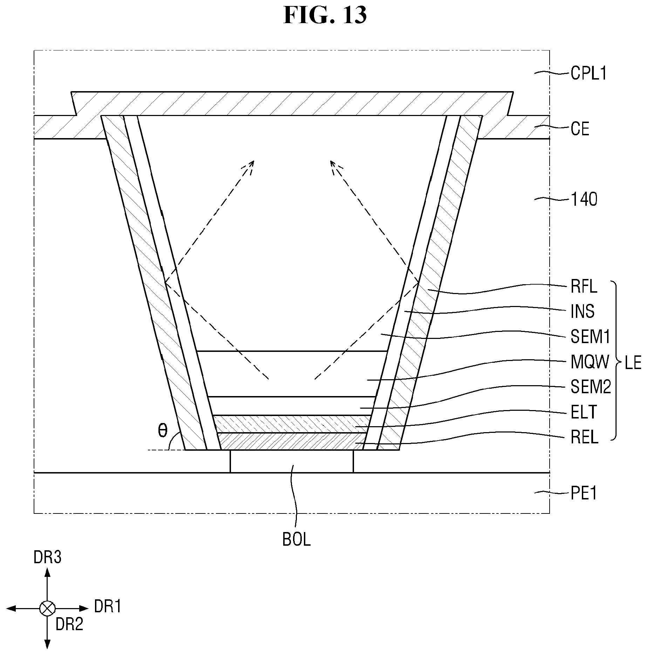

FIG. 9 is a graph showing the rate of luminance change versus the duration of driving of light-emitting elements. FIG. 10 is a schematic enlarged cross-sectional view of an area A of FIG. 8. FIG. 11 is a graph showing the variation of the reflectance of each wavelength band of light versus the number of layers that are alternately stacked in a reflective layer. FIG. 12 is a graph showing the variation of the reflectance of light of a wavelength of about 460 nm versus the number of layers that are alternately stacked in a reflective layer. FIG. 13 is a schematic enlarged cross-sectional view of a light-emitting element of FIG. 6.

Referring to FIG. 6, the display device 10 may include a display substrate 100 and a wavelength controller 200 and a color filter layer CFL, which are disposed on the display substrate 100.

The display substrate 100 may include a substrate 110 and a light-emitting element unit LEP, which is disposed on the substrate 110. The substrate 110 may be an insulating substrate. The substrate 110 may include a transparent material. For example, the substrate 110 may include a transparent insulating material such as glass or quartz. The substrate 110 may be a rigid substrate, but embodiments are not limited thereto. In another example, the substrate 110 may include plastic such as polyimide and may have flexibility such as bendability, foldability, or rollability. First, second, and third emission areas EA1, EA2, and EA3 and a non-emission area NEA may be defined on the substrate 110.

First, second, and third switching elements T1, T2, and T3 may be positioned on the substrate 110. The first, second, and third switching elements T1, T2, and T3 may be positioned in the first, second, and third emission areas EA1, EA2, and EA3, respectively, of the substrate 110, but embodiments are not limited thereto. In another example, at least one of the first, second, and third switching elements T1, T2, and T3 may be positioned in the non-emission area NEA.

The first, second, and third switching elements T1, T2, and T3 may be thin-film transistors (TFTs) including amorphous silicon, polysilicon, or an oxide semiconductor. For example, signal lines (e.g., gate lines, data lines, and power lines), which transmit signals to each of the first, second, and third switching elements T1, T2, and T3, may also be positioned on the substrate 110.

Each of the first, second, and third switching elements T1, T2, and T3 may include a semiconductor layer 65, a gate electrode 75, a source electrode 85a, and a drain electrode 85b. For example, a buffer layer 60 may be disposed on the substrate 110. The buffer layer 60 may cover the entire surface of the substrate 110. The buffer layer 60 may include silicon nitride, silicon oxide, or silicon oxynitride and may be formed as a single layer or a double layer.

Semiconductor layers 65 may be disposed on the buffer layer 60. The semiconductor layers 65 may be the channels of the first, second, and third switching elements T1, T2, and T3. The semiconductor layers 65 may include amorphous silicon, polycrystalline silicon, or an oxide semiconductor. For example, the oxide semiconductor may include a binary compound (ABₓ), a tertiary compound (ABₓC_{y}), or a quaternary compound (ABₓC_{y}D_{z}) containing indium (In), zinc (Zn), gallium (Ga), tin (Sn), titanium (Ti), aluminum (Al), hafnium (Hf), zirconium (Zr), or magnesium (Mg). The semiconductor layer 65 may include indium tin zinc oxide (IGZO).

A gate insulating layer 70 may be disposed on the semiconductor layers 65. The gate insulating layer 70 may include a silicon compound or a metal oxide. For example, the gate insulating layer 70 may include silicon oxide, silicon nitride, silicon oxynitride, aluminum oxide, tantalum oxide, hafnium oxide, zirconium oxide, or titanium oxide. The gate insulating layer 70 may include silicon oxide.

Gate electrodes 75 may be disposed on the gate insulating layer 70. The gate electrodes 75 may overlap the semiconductor layers 65. The gate electrodes 75 may include a conductive material. The gate electrodes 75 may include a metal oxide such as indium tin oxide (ITO), indium zinc oxide (IZO), indium tin zinc oxide (ITZO), or indium oxide (In₂O₃) or a metal such as copper (Cu), Ti, Al, molybdenum (Mo), tantalum (Ta), calcium (Ca), chromium (Cr), Mg, or nickel (Ni). For example, the gate electrodes 75 may be formed as Cu/Ti double layers in which Cu is stacked on Ti, but embodiments are not limited thereto.

First and second interlayer insulating layers 80 and 82 may be disposed on the gate electrodes 75. The first interlayer insulating layer 80 may be disposed (e.g., directly disposed) on the gate electrodes 75, and the second interlayer insulating layer 82 may be disposed (e.g., directly disposed) on the first interlayer insulating layer 80. The first and second interlayer insulating layers 80 and 82 may include an inorganic insulating material such as silicon oxide, silicon nitride, silicon oxynitride, hafnium oxide, aluminum oxide, titanium oxide, tantalum oxide, or zinc oxide, but embodiments are not limited thereto. In another example, the second interlayer insulating layer 82 may include an organic insulating material capable of planarizing the underlying step differences.

Source electrodes 85a and drain electrodes 85b may be disposed on the second interlayer insulating layer 82. The source electrodes 85a and the drain electrodes 85b may be in contact with the semiconductor layers 65 through contact holes passing through the first interlayer insulating layer 80, the second interlayer insulating layer 82, and the gate insulating layer 70. The source electrodes 85a and the drain electrodes 85b may include a metal oxide such as ITO, IZO, ITZO, or In₂O₃ or a metal such as Cu, Ti, Al, Mo, Ta, Ca, Cr, Mg, or Ni. For example, the source electrodes 85a and the drain electrodes 85b may be formed as Cu/Ti double layers in which Cu is stacked on Ti, but embodiments are not limited thereto.

A first planarization layer 120 may be disposed on the first, second, and third switching elements T1, T2, and T3. The first planarization layer 120 may include an organic material. For example, the first planarization layer 120 may include an acrylic resin, an epoxy resin, an imide resin, or an ester resin. The first planarization layer 120 may include a positive or negative photosensitive material.

Pixel connecting electrodes 125 may be disposed on the first planarization layer 120. The pixel connecting electrodes 125 may be disposed to correspond to the first, second, and third switching elements T1, T2, and T3 and may be electrically connected to the first, second, and third switching elements T1, T2, and T3. The pixel connecting electrodes 125 may connect the first, second, and third switching elements T1, T2, and T3 to first, second, and third pixel electrodes PE1, PE2, and PE3, respectively, that will be described later. The pixel connecting electrodes 125 may be in contact with the first, second, and third switching elements T1, T2, and T3 through contact holes passing through the first planarization layer 120.

A second planarization layer 130 may be disposed on the first planarization layer 120 and the pixel connecting electrodes 125. The second planarization layer 130 may planarize the underlying step differences. The second planarization layer 130 and the first planarization layer 120 may include the same material.

The light-emitting element unit LEP may be disposed on the second planarization layer 130. The light-emitting element unit LEP may include the first, second, and third pixel electrodes PE1, PE2, and PE3, light-emitting elements LE, and a common electrode CE.
The light-emitting element unit LEP may further include a pixel-defining film PDL, which defines and divides the first, second, and third emission areas EA1, EA2, and EA3, and an organic layer 140.

The first, second, and third pixel electrodes PE1, PE2, and PE3 may function as first electrodes of the light-emitting elements LE and may be anodes or cathodes. The first, second, and third pixel electrodes PE1, PE2, and PE3 may be positioned in the first, second, and third emission areas EA1, EA2, and EA3, respectively. The first, second, and third pixel electrodes PE1, PE2, and PE3 may overlap (e.g., completely overlap) the first, second, and third emission areas EA1, EA2, and EA3, respectively.

The first, second, and third pixel electrodes PE1, PE2, and PE3 may be connected (e.g., directly connected) to the pixel connecting electrodes 125 through contact holes penetrating the second planarization layer 130 and may be electrically connected to the first, second, and third switching elements T1, T2, and T3, respectively, via the pixel connecting electrodes 125. The first, second, and third pixel electrodes PE1, PE2, and PE3 may include a metal. The metal may be, for example, Cu, Ti, silver (Ag), Mg, Al, platinum (Pt), lead (Pb), gold (Au), Ni, neodymium (Nd), iridium (Ir), Cr, lithium (Li), Ca, or a mixture thereof. The first, second, and third pixel electrodes PE1, PE2, and PE3 may have a multilayer structure in which two or more metal layers are stacked. For example, the first, second, and third pixel electrodes PE1, PE2, and PE3 may have a double-layer structure in which Cu is stacked on Ti, but embodiments are not limited thereto.

The light-emitting elements LE may be disposed on the first, second, and third pixel electrodes PE1, PE2, and PE3.

As illustrated in FIGS. 6 and 7, the light-emitting elements LE may be disposed in the first, second, and third emission areas EA1, EA2, and EA3. The light-emitting elements LE may be vertical light-emitting diodes (LEDs) extending in the third direction DR3. For example, the length, in the third direction DR3, of the light-emitting elements LE may be greater than the length, in a horizontal direction, of the light-emitting elements LE. For example, the horizontal direction may refer to the first or second direction DR1 or DR2. The light-emitting elements LE will be described later in detail.

The organic layer 140 may be disposed on the first, second, and third pixel electrodes PE1, PE2, and PE3 and the pixel-defining film PDL. The organic layer 140 may planarize the underlying step differences such that the common electrode CE may be properly formed on the organic layer 140. The organic layer 140 may have a predetermined height and to allow at least parts of the light-emitting elements LE to protrude beyond the top of the organic layer 140. For example, the height of the organic layer 140 from the top surface (or upper surface) of the first pixel electrode PE1 may be less than the height of the light-emitting element LE.

The organic layer 140 may include an organic material to planarize the underlying step differences. For example, the organic layer 140 may include an acrylic resin, an epoxy resin, a phenolic resin, a polyamide resin, a polyimide resin, an unsaturated polyester resin, a polyphenylene resin, a polyphenylene sulfide resin, or benzocyclobutene (BCB).

The common electrode CE may be disposed on the organic layer 140 and the light-emitting elements LE. For example, the common electrode CE may be disposed on one surface of the substrate 110 where the light-emitting elements LE are formed, over the entire display area DPA. The common electrode CE may overlap the first, second, and third emission areas EA1, EA2, and EA3, in the display area DPA, and may be formed be thin enough to allow light to be emitted therethrough.

The common electrode CE may be disposed (e.g., directly disposed) on the top surfaces (or upper surfaces) and the side surfaces of the light-emitting elements LE. For example, the common electrode CE may be in contact with (e.g., in direct contact with) second semiconductor layers SEM2, which form the top surfaces (or upper surfaces) of the light-emitting elements LE, and with reflective layers RF, which form the side surfaces of the light-emitting elements LE. The common electrode CE may cover the light-emitting elements LE and may be a common layer provided in common for all the light-emitting elements LE to connect the light-emitting elements LE.

As the common electrode CE is disposed on the entire substrate 110 and a common voltage is applied to the common electrode CE, the common electrode CE may include a low-resistance material. For example, the common electrode CE may be thin enough to readily transmit light therethrough. For example, the common electrode CE may include a low-resistance metal material such as Al, Ag, or Cu or a metal oxide such as ITO, IZO, or ITZO. The thickness of the common electrode CE may be about 10Å to about 200 Å, but embodiments are not limited thereto.

The light-emitting elements LE may receive a pixel voltage or an anode voltage from the first, second, and third pixel electrodes PE1, PE2, and PE3 and may receive a common voltage from the common electrode CE. The light-emitting elements LE may emit light at a predetermined luminance in accordance with the difference between the pixel voltage and the common voltage. As the light-emitting elements LE, for example, inorganic LEDs, are disposed on the first, second, and third pixel electrodes PE1, PE2, and PE3, the problems associated with OLEDs that are vulnerable to moisture or oxygen from the outside, may be solved, and the lifetime and the reliability of the display device 10 may be improved.

As illustrated in FIG. 7, the light-emitting elements LE may be disposed on the first, second, and third pixel electrodes PE1, PE2, and PE3. The light-emitting elements LE may be regularly arranged. For example, the light-emitting elements LE may be spaced apart from one another at regular intervals, but embodiments are not limited thereto. In another example, the light-emitting elements LE may be irregularly arranged.

The light-emitting elements LE may generally be disposed on the first, second, and third pixel electrodes PE1, PE2, and PE3, but embodiments are not limited thereto. In another example, some of the light-emitting elements LE may be disposed between the first, second, and third pixel electrodes PE1, PE2, and PE3, may be disposed in part on the first, second, and third pixel electrodes PE1, PE2, and PE3, or may not be disposed on any of the first, second, and third pixel electrodes PE1, PE2, and PE3.

A first capping layer CPL1 may be disposed on the substrate 110 where the common electrode CE is disposed. The first capping layer CPL1 may be disposed (e.g.., directly disposed) on the common electrode CE. The first capping layer CPL1 may cover the elements disposed therebelow, for example, the light-emitting elements LE and the common electrode CE, and may thus protect the light-emitting elements LE and the common electrode CE from moisture and a foreign material.

The first capping layer CPL1 may include an inorganic material. For example, the first capping layer CPL1 may include at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. The first capping layer CPL1 is illustrated as being formed as a single layer, but embodiments are not limited thereto. For example, the first capping layer CPL1 may be formed as a multilayer in which inorganic layers including at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride are alternately stacked. The thickness of the first capping layer CPL1 may be about 0.05 µm to about 2 µm, but embodiments are not limited thereto.

The wavelength controller 200 may be disposed on the light-emitting element unit LEP. The wavelength controller 200 may include a first wavelength conversion layer WCL1, a second wavelength conversion layer WCL2, and a light-transmitting layer TPL. The wavelength controller 200 may further include a bank layer BNL.

The bank layer BNL may be disposed on the first capping layer CPL1 and may divide the first, second, and third emission areas EA1, EA2, and EA3. The bank layer BNL may extend in the first and second directions DR1 and DR2 and may form a lattice pattern over the entire display area DPA. The bank layer BNL may not overlap the first, second, and third emission areas EA1, EA2, and EA3 and may overlap the non-emission area NEA.

The bank layer BNL may provide space, in which the first wavelength conversion layer WCL1, the second wavelength conversion layer WCL2, and the light-transmitting layer TPL are disposed. For example, the bank layer BNL may have a thickness of about 1 *µ*m to about 10 *µ*m. The bank layer BNL may include an organic insulating material to have sufficiently thick. The organic insulating material may include, for example, an epoxy resin, an acrylic resin, a cardo resin, or an imide resin.

The bank layer BNL may further include a light-blocking material and a pigment or dye capable of blocking light. For example, the bank layer BNL may be a black matrix. External light incident from outside the display device 10 may distort the color gamut of the wavelength controller 200. As the bank layer BNL, which includes a light-blocking material, is disposed in the wavelength controller 200, the distortion of colors that may be caused by the reflection of external light may be reduced. For example, the bank layer BNL, which may include a light-blocking material, may prevent light from penetrating between neighboring emission areas and may prevent color mixture. Accordingly, the color gamut of the wavelength controller 200 may be further improved.

The first wavelength conversion layer WCL1, the second wavelength conversion layer WCL2, and the light-transmitting layer TPL may be disposed in the first, second, and third emission areas EA1, EA2, and EA3, respectively. The first and second wavelength conversion layers WCL1 and WCL2 may convert or shift incident light into light having a certain peak wavelength and may output the light having the certain peak wavelength. The first wavelength conversion layer WCL1 may convert blue light, emitted from the light-emitting elements LE, into red light, and the second wavelength conversion layer WCL2 may convert the blue light into green light. The light-transmitting layer TPL may transmit the blue light therethrough as it is.

The first wavelength conversion layer WCL1, the second wavelength conversion layer WCL2, and the light-transmitting layer TPL may be disposed in the first, second, and third emission areas EA1, EA2, and EA3, respectively, which are divided by the bank layer BNL, and may be spaced apart from one another. For example, the first wavelength conversion layer WCL1, the second wavelength conversion layer WCL2, and the light-transmitting layer TPL may be formed as dot-shaped island patterns that are spaced apart from one another.

The first wavelength conversion layer WCL1 may overlap the first emission area EA1. The first wavelength conversion layer WCL1 may convert or shift incident light into light having a certain peak wavelength. The first wavelength conversion layer WCL1 may convert blue light, emitted from the light-emitting element LE in the first emission area EA1, into red light having a single peak wavelength of about 610 nm to about 650 nm.

The first wavelength conversion layer WCL1 may include a first base resin BRS1, first wavelength conversion particles WCP1, and a scatterer SCP. The first base resin BRS 1 may include a light-transmitting organic material. For example, the first base resin BRS1 may include an epoxy resin, an acrylic resin, a cardo resin, or an imide resin.

The first wavelength conversion particles WCP1 may convert blue light, incident thereupon from the light-emitting elements LE, into red light. For example, the first wavelength conversion particles WCP1 may convert blue-wavelength light into redwavelength light. The first wavelength conversion particles WCP1 may be quantum dots (QDs), quantum rods, a fluorescent material, or a phosphorescent material. For example, the quantum dots (QDs) may be a particulate material capable of emitting light of a certain color in response to the transition of electrons from the conduction band to the valence band.

The quantum dots (QDs) may be a semiconductor nanocrystal material. Since the quantum dots (QDs) have a predetermined band gap depending on their composition and size, the quantum dots (QDs) absorb light and emit light of a predetermined wavelength. The semiconductor nanocrystal material include a group IV element, a group II-VI compound, a group III-V compound, a group IV-VI compound, and a combination thereof.

The group II-VI compound may be selected from the group consisting of: a binary compound selected from among CdSe, CdTe, ZnS, ZnSe, ZnTe, ZnO, HgS, HgSe, HgTe, MgSe, MgS, and a mixture thereof; a ternary compound selected from among InZnP, AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; or a quaternary compound selected from among HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The group III-V compound may be selected from the group consisting of: a binary compound selected from among GaN, GaP, GaAs, GaSb, AlN, AlP, AlAs, AlSb, InN, InP, InAs, InSb, and a mixture thereof; a ternary compound selected from among GaNP, GaNAs, GaNSb, GaPAs, GaPSb, A1NP, AlNAs, AlNSb, AlPAs, AlPSb, InGaP, InNP, InAlP, InNAs, InNSb, InPAs, InPSb, GaAlNP, and a mixture thereof; and a quaternary compound selected from among GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof.

The group IV-VI compound may be selected from the group consisting of: a binary compound selected from among SnS, SnSe, SnTe, PbS, PbSe, PbTe, and a mixture thereof; a ternary compound selected from among SnSeS, SnSeTe, SnSTe, PbSeS, PbSeTe, PbSTe, SnPbS, SnPbSe, SnPbTe, and a mixture thereof; and a quaternary compound selected from among SnPbSSe, SnPbSeTe, SnPbSTe, and a mixture thereof. The group IV element may be selected from the group consisting of silicon (Si), germanium (Ge), and a mixture thereof. The group IV compound may be a binary compound selected from among SiC, SiGe, and a mixture thereof.

These binary, ternary, or quaternary compounds may exist in a uniform concentration or in a partially different concentration in particles. The quantum dots (QDs) may have a core-shell structure in which one quantum dot surrounds another quantum dot. The interfaces between the cores and the shells of the quantum dots (QDs) may have a concentration gradient in which the concentration of the element(s) at the shells of the quantum dots (QDs) gradually decreases toward the centers of the shells of the quantum dots QDs).

For example, the quantum dots (QDs) may have a core-shell structure with a core including the above-described semiconductor nanocrystal material and a shell surrounding the core. The shells of the quantum dots (QDs) may function as protective layers for maintaining the semiconductor characteristics of the quantum dots (QDs) by preventing chemical denaturation of the cores of the quantum dots (QDs) and/or as charging layers for imparting electrophoretic characteristics to the quantum dots (QDs). The shells of the quantum dots (QDs) may have a single-layer structure or a multilayer structure. The shells of the quantum dots (QDs) may include a metal or non-metal oxide, a semiconductor compound, or a combination thereof.

For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO or a ternary compound such as MgAl₂O₄, CoFe₂O₄, NiFe₂O₄, or CoMn₂O₄, but embodiments are not limited thereto.

The semiconductor compound may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, or AlSb, but embodiments are not limited thereto.

The scatterer SCP may scatter light from the light-emitting elements LE in random directions. The scatterer SCP may have a different refractive index from the first base resin BRS1 and may form an optical interface with the first base resin BRS1. For example, the scatterer SCP may be light-scattering particles. The material of the scatterer SCP of embodiments is not limited as long as the scatterer SCP may scatter at least some light. For example, the scatterer SCP may be particles of a metal oxide or an organic material. For example, the metal oxide may be titanium oxide (TiO₂), zirconium oxide (ZrO₂), aluminum oxide (Al₂O₃), In₂O₃, zinc oxide (ZnO), or tin oxide (SnO₂), and the organic material may be an acrylic resin or a urethane resin. The scatterer SCP may scatter light in random directions regardless of the incident direction of incident light, without substantially changing the wavelength of the incident light.

The second wavelength conversion layer WCL2 may overlap the second emission area EA2. The second wavelength conversion layer WCL2 may convert or shift incident light into light having a certain peak wavelength. The second wavelength conversion layer WCL2 may convert blue light, emitted from the light-emitting element LE in the second emission area EA2, into green light having a single peak wavelength of about 510 nm to about 550 nm.

The second wavelength conversion layer WCL2 may include a second base resin BRS2 and second wavelength conversion particles WCP2, and a scatterer SCP, which are dispersed in the second base resin BRS2.

The second base resin BRS2 may be formed of a material with high light transmittance. The second base resin BRS2 and the first base resin BRS1 may be formed of the same material. The second base resin BRS2 may include at least one of the aforementioned materials for forming the first base resin BRS1.

The second wavelength conversion particles WCP2 may convert incident light into light having a certain peak wavelength. For example, the second wavelength conversion particles WCP2 may convert blue light provided by the light-emitting elements LE into green light having a peak wavelength of about 510 nm to about 550 nm. The second wavelength conversion particles WCP2 may be quantum dots (QDs), quantum rods, a fluorescent material, or a phosphorescent material. The second wavelength conversion particles WCP2 and the first wavelength conversion particles WCP1 are substantially the same as each other, and thus, a redundant description thereof will be omitted for descriptive convenience.

The light-transmitting layer TPL may overlap the third emission area EA3. The light-transmitting layer TPL may transmit incident light therethrough. The light-transmitting layer TPL may transmit light, emitted from the light-emitting element LE in the third emission area EA3, therethrough as it is. The light-transmitting layer TPL may include a third base resin BRS3 and a scatterer SCP, which is dispersed in the third base resin BRS3. The third base resin BRS3 may be substantially the same as the first base resin BRS1, and thus, a redundant description thereof will be omitted for descriptive convenience.

Light transmitted through the wavelength controller 200 may realize full colors through the color filter layer CFL.

The wavelength controller 200 may further include a second capping layer CPL2.
The second capping layer CPL2 may cover the first wavelength conversion layer WCL1, the second wavelength conversion layer WCL2, the light-transmitting layer TPL, and the bank layer BNL and may thus protect the first wavelength conversion layer WCL1, the second wavelength conversion layer WCL2, the light-transmitting layer TPL, and the bank layer BNL from moisture or a foreign material. The second capping layer CPL2 may include an inorganic material. The second capping layer CPL2 and the first capping layer CPL1 may include substantially the same material as each other, or a similar material to each other.

A low refractive index layer LRL and a third capping layer CPL3 may be disposed on the second capping layer CPL2.

The low refractive index layer LRL may be disposed over the first, second, and third emission areas EA1, EA2, and EA3 and the non-emission area NEA. The low refractive index layer LRL may have a low refractive index. For example, the low refractive index layer LRL may have a refractive index of about 1.1 to about 1.4.

The low refractive index layer LRL may reflect some of light emitted in a bottom-to-top direction (e.g., the third direction DR3), back toward the substrate 110. For example, the low refractive index layer LRL may improve the light output efficiency of the light-emitting element LE by recycling at least some of light emitted in an upward direction, and thus, the optical efficiency of the display device 10 may be improved. The low refractive index layer LRL may include an organic material and may include particles dispersed therein. The particles may include, for example, hollow silica particles.

The third capping layer CPL3 may be disposed on the low refractive index layer LRL. The third capping layer CPL3 may prevent the low refractive index layer LRL from being damaged by, or contaminated with, impurities such as moisture or the air from the outside.

The color filter layer CFL may be disposed on the third capping layer CPL3. The color filter layer CFL may include a first color filter CF1, a second color filter CF2, a third color filter CF3, and an overcoat layer OC.

The first, second, and third color filters CF1, CF2, and CF3 may be disposed on the third capping layer CPL3. The first, second, and third color filters CF1, CF2, and CF3 may be disposed in the first, second, and third emission areas EA1, EA2, and EA3, respectively.

Each of the first, second, and third color filters CF1, CF2, and CF3 may include a colorant such as a dye or pigment capable of absorbing all wavelengths other than a certain wavelength. The first color filter CF1 may selectively transmit red light therethrough and block or absorb glue light and green light. The second color filter CF2 may selectively transmit green light therethrough and block or absorb blue light and red light. The third color filter CF3 may selectively transmit blue light therethrough and block or absorb red light and green light. For example, the first, second, and third color filters CF1, CF2, and CF3 may be red, green, and blue color filters, respectively.

Light incident upon the first color filter CF1 may be red light generated by the first wavelength conversion layer WCL1, light incident upon the second color filter CF2 may be green light generated by the second wavelength conversion layer WCL2, and light incident upon the third color filter CF3 may be blue light transmitted through the light-transmitting layer TPL. Thus, red light, green light, and blue light may be emitted through the first, second, and third color filters CF1, CF2, and CF3, respectively, in an upward direction from the substrate 110, thereby realizing full colors.

The first, second, and third color filters CF1, CF2, and CF3 may reduce the reflection of external light by absorbing some of the external light. Accordingly, the first, second, and third color filters CF1, CF2, and CF3 may prevent color distortion caused by the reflection of the external light.

The first color filter CF1 may be disposed in the non-emission area NEA, and at least one of the second and third color filters CF2 and CF3 may overlap the non-emission area NEA. For example, the first, second, and third color filters CF1, CF2, and CF3 may be disposed in the non-emission area NEA.

Accordingly, the first, second, and third color filters CF1, CF2, and CF3 not only block the emission of light from the display device 10, in the non-emission area NEA, but also suppress the reflection of external light. The first, second, and third color filters CF1, CF2, and CF3 may block the emission of light of other colors than those designated for the first, second, and third emission areas EA1, EA2, and EA3, and thus, red light, green light, and blue light may all be blocked in the non-emission area NEA. However, embodiments are not limited thereto. In another example, a light-absorbing member including a light-absorbing material capable of absorbing a visible wavelength band may be disposed in the non-emission area NEA.

The overcoat layer OC may be disposed on the color filer layer CFL. The overcoat layer OC may be disposed (e.g., directly disposed) on the color filter layer CFL. The overcoat layer OC may be disposed in the entire display area DPA and may have a flat surface. The overcoat layer OC may planarize step differences generated by the color filter layer CFL. The overcoat layer OC may include a light-transmitting organic material.

Referring to FIG. 8, a light-emitting element LE, which is a particulate device, may have a rod or cylindrical shape with a predetermined aspect ratio. The light-emitting element LE may have a nanometer scale (e.g., a size of about 1 nm to about 1 µm) or a micrometer scale (e.g., a size of 1 µm to 1 mm). For example, an array of light-emitting elements LE may have a diameter and a length of nanometer scale or a diameter and a length of micrometer scale. In another example, an array of light-emitting elements LE may have a diameter of nanometer scale and a length of micrometer scale. In yet another example, some of an array of light-emitting elements LE may have a diameter and/or a length of nanometer scale, and the other light-emitting elements LE may have a diameter and/or a length of micrometer scale.

The light-emitting element LE may be an inorganic LED. For example, the light-emitting element LE may include semiconductor layers doped with impurities of an arbitrary conductivity type (e.g., a p type dopant or an n type dopant). The semiconductor layers may receive electrical signals from an external power source to emit light of a certain wavelength band.

The light-emitting element LE may include a first semiconductor layer SEM1, a light-emitting layer MQW, a second semiconductor layer SEM2, a device electrode layer ELT, and a reflective electrode layer REL. The light-emitting element LE may further include an insulating film INS, which surrounds the outer surfaces of the first semiconductor layer SEM1, the light-emitting layer MQW, the second semiconductor layer SEM2, the device electrode layer ELT, and the reflective electrode layer REL, and a reflective layer RFL, which surrounds the insulating film INS.

The first semiconductor layer SEM1 may be an n-type semiconductor. In a case where the light-emitting element LE emits light of a blue wavelength band, the first semiconductor layer SEM1 may include a semiconductor material, e.g., AlₓGa_{y}In_{1**-x**-y}N **(**where 0≤x≤1.0≤y≤1, and 0≤x+y≤1), and the semiconductor material may be one of, for example, AlGaInN, GaN, AlGaN, InGaN, AlN, and InN that are doped with an n-type dopant. The first semiconductor layer SEM1 may be doped with an n-type dopant, and the n-type dopant may be Si, Ge, or Sn. For example, the first semiconductor layer SEM1 may include n-GaN doped with n-type Si. The first semiconductor layer SEM1 may have a length of about 1.5 *µ*m to about 5 *µ*m, but embodiments are not limited thereto.

The light-emitting layer MQW may be disposed on the first semiconductor layer SEM1. The light-emitting layer MQW may emit light through the combination of electronhole pairs in response to electrical signals applied thereto via the first and second semiconductor layers SEM1 and SEM2. The light-emitting layer MQW may emit blue-wavelength light having a central wavelength of about 450 nm to about 495 nm.

The light-emitting layer MQW may include a material having a single-quantum well structure or a multi-quantum well structure. In a case where the light-emitting layer MQW includes a material having a multi-quantum well structure, the light-emitting layer MQW may have a structure in which multiple quantum layers and multiple well layers are alternately stacked. For example, the well layers may be formed of InGaN, and the barrier layers may be formed of GaN or AlGaN. However, embodiments are not limited thereto. The well layers may have a thickness of about 1 nm to about 4 nm, and the barrier layers may have a thickness of about 3 nm to about 10 nm.

In another example, the light-emitting layer MQW may have a structure in which a semiconductor material having a large band gap energy and a semiconductor material having a small band gap energy are alternately stacked or may include group III or group V semiconductor materials depending on the wavelength of light to be emitted. The type of light emitted by the light-emitting layer MQW is not limited thereto. The light-emitting layer MQW may emit light of a red or green wavelength band as necessary, instead of blue light. In a case where the light-emitting layer MQW include indium (In), the color of the light emitted by the light-emitting layer MQW may vary according to the content of the indium (In) of the light-emitting layer MQW.

The second semiconductor layer SEM2 may be disposed on the light-emitting layer MQW. The second semiconductor layer SEM2 may be a p-type semiconductor and may include a semiconductor material, e.g., AlₓGa_{y}In_{1-x-y}N (where 0≤x≤1,0≤y≤1, and 0≤x+y≤1), and the semiconductor material may be one of, for example, AlGaInN, GaN, AlGaN, InGaN, AlN, and InN that are doped with a p-type dopant. The second semiconductor layer SEM2 may be doped with a p-type dopant, and the p-type dopant may be Mg, Zn, Ca, or barium (Ba). For example, the second semiconductor layer SEM2 may include p-GaN, which is doped with magnesium (Mg). The second semiconductor layer SEM2 may have a thickness of about 30 nm to about 200 nm, but embodiments are not limited thereto.

The device electrode layer ELT may be disposed on the second semiconductor layer SEM2. The device electrode layer ELT may be an ohmic connecting electrode, but embodiments are not limited thereto. In another example, the device electrode layer ELT may be a Schottky connecting electrode. The light-emitting element LE may include at least one device electrode layer ELT. FIG. 8 illustrates that the light-emitting element LE includes a device electrode layer ELT, but in another example, the light-emitting element LE may include more than one device electrode layer ELT.

The device electrode layer ELT may include a conductive metal. For example, the device electrode layer ELT may include at least one of Al, Ti, In, Au, Ag, ITO, IZO, and ITZO. The device electrode layer ELT may include a semiconductor material doped with an n- or p-type dopant.

The reflective electrode layer REL may be disposed on the device electrode layer ELT. The reflective electrode layer REL may reflect light emitted from the light-emitting layer MQW and may function as an electrode electrically connecting a pixel electrode and the device electrode layer ELT. The reflective electrode layer REL may include a conductive metal material having a high light reflectance. The reflective electrode layer REL may include, for example, Al, Ag, or an alloy thereof.

The reflective electrode layer REL and the device electrode layer ELT may have the same size as each other. For example, the area (or size) of the reflective electrode layer REL and the area (or size) of the device electrode layer ELT may be the same as each other. The size of the bottom surface (or lower surfaces) of the reflective electrode layer REL and the size of the top surface (or upper surface) of the device electrode layer ELT may be the same as each other. The side surface of the reflective electrode layer REL may be aligned with the side surface of the device electrode layer ELT. As the reflective electrode layer REL and the device electrode layer ELT have the same size, the reflective electrode layer REL may properly reflect light emitted from the light-emitting layer MQW and may thus improve the light output efficiency of the light-emitting element LE.

The insulating film INS may surround the outer surfaces of the first semiconductor layer SEM1, the light-emitting layer MQW, the second semiconductor layer SEM2, the device electrode layer ELT, and the reflective electrode layer REL. For example, the term "outer surface" may refer an outer circumferential surface, an outer side surface, or a side surface. For example, the insulating film INS may surround the outer surface of at least the light-emitting layer MQW and may extend in the direction in which the light-emitting element LE extends. The insulating film INS may protect the other members of the light-emitting element LE. The insulating film INS may surround the side surfaces of the other members of the light-emitting element LE and expose end portions (e.g., opposite end portion), in a lengthwise direction, of the light-emitting element LE.

The insulating film INS is illustrated as extending in the lengthwise direction of the light-emitting element LE to cover the side surfaces of the other members of the light-emitting element LE, ranging from the first semiconductor layer SEM1 to the reflective electrode layer REL, but embodiments are not limited thereto. The insulating film INS may have a rounded top near at least one end portion of the light-emitting element LE, in a cross-sectional view.

The insulating film INS may include an insulating material such as, for example, an oxide, a fluoride, a nitride, or an organic-hybrid material. For example, the insulating film INS may include at least one of: an oxide such as Al₂O₃, HfO₂, SiO₂, TiO₂, SrTiO₃, Ta₂O₅, Gd₂O₃, ZrO₂, Ga₂O₃, V₂O₅, Co₃O₄, ZnO, ZnO:Al, ZnO:B, In₂O₃:H, WO₃, MoOs, Nb₂O₅, NiO, MgO, or RuO₂; a fluoride such as MgF₂ or AlF₃; a nitride such as TiN, TaN, Si₃N₄, AlN, GaN, WN, HfN, NbN, GdN, VN, or ZrN; and an organic-hybrid material such as alucone.

The insulating film INS may have a thickness of about 0.5 nm to about 1.0 *µ*m, but embodiments are not limited thereto. For example, the insulating film INS may have a thickness of about 10 nm to about 30 nm.

The insulating film INS may be formed as a single layer or multiple layers including one or more insulating materials. As the insulating film INS includes one or more insulating layers, the insulating film INS may prevent the first semiconductor layer SEM1, the light-emitting layer MQW, and the second semiconductor layer SEM2 from being degraded due to the diffusion of oxygen from the insulating film INS into the first semiconductor layer SEM1, the light-emitting layer MQW, and the second semiconductor layer SEM2. For example, the insulating film INS may prevent an electrical short circuit that may be caused when the light-emitting element LE is placed in contact with an electrode to which electrical signals are transmitted. For example, as the insulating film INS may protect the outer surface of the light-emitting element LE, including the light-emitting layer MQW, the insulating film INS may prevent the emission efficiency of the light-emitting element LE from decreasing.

Table 1 below shows the quantum efficiencies and the momentary afterimages of light-emitting elements LE including multilayer insulating films INS, and FIG. 9 shows the rate of luminance change with the duration of driving of the light-emitting elements LE.

**[Table 1]**

| # | Stacking Orders and Materials of Insulating Films | Quantum Efficiency (A/cm²) | Momentary Afterimage (ms) | |
|---|---|---|---|---|
| | | | Low | High |
| Experimental Example 1 | HfO₂/SiO₂/Al₂O₃ (Triple Layer) | 16.3 ± 0.5 | 92 | 26 |
| Experimental Example 2 | HfO₂/Al₂O₃/SiO₂/Al₂O₃ (Quadruple Layer) | 17.6 ± 0.3 | 6 | 1 |
| Experimental Example 3 | HfO₂/Al₂O₃/ZrO₂/SiO₂/Al₂O₃ (Quintuple Layer) | 19.7 ± 0.5 | 1 | 1 |

Referring to Table 1 and FIG. 9, as the number of layers stacked in each of the multilayer insulating films INS increases from 3 to 5, the quantum efficiency of the light-emitting elements LE increases, and the momentary afterimage of the light-emitting elements LE is improved.

Accordingly, it is clear that both the quantum efficiency and the momentary afterimage of the light-emitting elements LE may be improved by forming the insulating films INS as multilayer films.

Referring again to FIG. 8, the reflective layer RFL may surround the outer surface of the insulating film INS. For example, the reflective layer RFL may surround the outer surface of the insulating film INS and may extend in the direction in which the light-emitting element LE extends. The reflective layer RFL may reflect light emitted from the light-emitting layer MQW and may thus emit the light to the side of the first semiconductor layer SEM1. The reflective layer RFL may expose end portions (e.g., opposite end portion), in the lengthwise direction, of the light-emitting element LE.

Referring to FIG. 10, the reflective layer RFL may be a distributed Bragg reflector (DBR). The reflective layer RFL may include layers to function as a DBR. First layers R1 and second layers R2 may be alternately stacked in the reflective layer RFL. The first layers R1 may be odd-numbered layers of the reflective layer RFL, and the second layers R2 may be even-numbered layers of the reflective layer RFL. The refractive index of the first layers R1 may be higher than the refractive index of the second layers R2. For example, the first layers R1 may be high refractive index layers, and the second layers R2 may be low refractive index layers. The reflective layer RFL may have a structure in which high refractive index layers and low refractive index layers are alternately stacked.

The reflective layer RFL may include an insulating material such as an oxide, a fluoride, a nitride, or an organic-hybrid material. For example, the reflective layer RFL may include at least one of: an oxide such as Al₂O₃, HfO₂, SiO₂, TiO₂, SrTiO₃, Ta₂O₅, Gd₂O₃, ZrO₂, Ga₂O₃, V₂O₅, Co₃O₄, ZnO, ZnO:Al, ZnO:B, In₂O₃:H, WO₃, MoOs, Nb₂O₅, NiO, MgO, or RuO₂; a fluoride such as MgF₂ or AlF₃; a nitride such as TiN, TaN, Si₃N₄, AlN, GaN, WN, HfN, NbN, GdN, VN, or ZrN; and an organic-hybrid material such as alucone. The thickness of the reflective layer RFL may be about 0.5 nm to about 1.0 *µ*m, but embodiments are not limited thereto.

FIG. 11 is a graph showing the variation of the reflectance of each wavelength band of light versus the number of layers that are alternately stacked in a reflective layer. FIG. 12 is a graph showing the variation of the reflectance of light of a wavelength of about 460 nm versus the number of layers that are alternately stacked in a reflective layer.

Referring to FIGS. 11 and 12, the term "pair" refers to a pair formed by one first layer R1 and one second layer R2.

As the number of pairs of first and second layers R1 and R2 in the reflective layer RFL increases, the reflectance of the reflective layer RFL for a wavelength band of about 400 nm to about 550 nm increases. The reflectance of the reflective layer RFL for blue light of a wavelength of about 460 nm may be 100% in case that the number of pairs of first and second layers R1 and R2 of the reflective layer RFL is 10.

As the reflective layer RFL surrounds the outer surface of the insulating film INS, light emitted from the light-emitting layer MQW may be reflected, and thus, the light output efficiency of the light-emitting element LE may be improved.

In another example, the reflective layer RFL may include a metal. The reflective layer RFL may include a metal with high reflectance. For example, the reflective layer RFL may be formed as a single layer or a multilayer including Ag, Cu, Al, Ti, or Ni. The reflective layer RFL may be formed as a Ti/Cu double layer, a Ti/Al double layer, a Ni/Al double layer, or an Ag/Al-Si alloy double layer.

FIG. 8 illustrates that the side surfaces of the layers of the light-emitting element LE are perpendicularly aligned with one another, but embodiments are not limited thereto. In another example, the width of the side surfaces of the layers of the light-emitting element LE may gradually decrease in a direction from the first semiconductor layer SEM1 to the reflective electrode layer REL. For example, the diameter of the light-emitting element LE may gradually decrease in the direction from the first semiconductor layer SEM1 to the reflective electrode layer REL.

Referring to FIGS. 6 and 13, a light-emitting element LE may be disposed on the first pixel electrode PE1. FIG. 13 illustrates the light-emitting element LE on the first pixel electrode PE1.

The light-emitting element LE may be disposed such that a reflective electrode layer REL of the light-emitting element LE may face the first pixel electrode PE1. The light-emitting element LE may further include a connecting electrode BOL. The connecting electrode BOL may transmit an emission signal from the first pixel electrode PE1 to the light-emitting element LE. The connecting electrode BOL may be disposed at the lowermost portion of the light-emitting element LE, further away from a light-emitting layer MQW than the reflective electrode layer REL. The connecting electrode BOL may include at least one of Au, Cu, Sn, Ag, Al, and Ti. For example, the connecting electrode BOL may include an Au-Sn alloy (Au:Sn=9: 1, 8:2, or 7:3) or a Cu-Ag-Sn alloy (e.g., SAC305).

As illustrated in FIG. 13, the side surface of the light-emitting element LE may form an angle θ of 90 degrees or less with the bottom surface (or lower surface) of the reflective electrode layer REL. In a case where the side surface of the light-emitting element LE is inclined, light emitted from the light-emitting layer MQW may be readily reflected by a reflective layer RFL of the light-emitting element LE and may thus be readily emitted in an upward direction from the light-emitting element LE. Accordingly, the light output efficiency of the light-emitting element LE may be further improved.

As already mentioned above, as the light-emitting element LE includes a multilayer insulating film INS, the light emission efficiency and the momentary afterimage of the light-emitting element LE may be improved. As the light-emitting element LE further includes the reflective layer RFL, the optical efficiency of the light-emitting element LE may be improved.

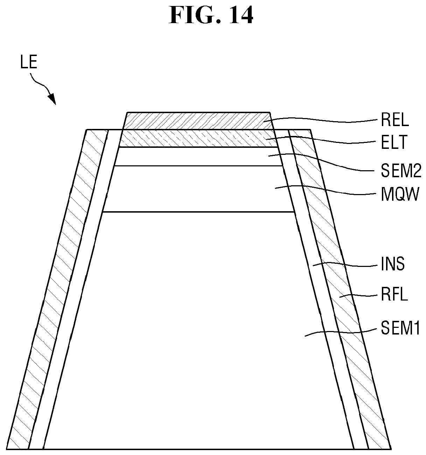

FIG. 14 is a schematic cross-sectional view of a light-emitting element according to another embodiment.

The embodiment of FIG. 14 differs from the embodiment of FIGS. 6 through 13 in that an insulating film INS and a reflective layer RFL are not disposed on the outer surface of a reflective electrode layer REL. The embodiment of FIG. 14 will hereinafter be described, focusing on the differences with the embodiment of FIGS. 6 through 13 for descriptive convenience.

Referring to a light-emitting element LE of FIG. 14, an insulating film INS may surround the outer surfaces of a first semiconductor layer SEM1, a light-emitting layer MQW, a second semiconductor layer SEM2, and a device electrode layer ELT. The insulating film INS may surround the side surfaces of the first semiconductor layer SEM1, the light-emitting layer MQW, the second semiconductor layer SEM2, and the device electrode layer ELT, but may not surround the outer surface of a reflective electrode layer REL. A reflective layer RFL may surround the outer surface of the insulating film INS. The reflective layer RFL may surround the side surface of the insulating film INS, but may not surround the outer surface of the reflective electrode layer REL.

The top surface (or upper surface) of the device electrode layer ELT, e.g., a surface of the device electrode layer ELT that is in contact with the reflective electrode layer REL, may be aligned with the top surfaces (or upper surface) of the insulating film INS and the reflective layer RFL. The reflective electrode layer REL and the reflective layer RFL, which are for reflecting light emitted from the light-emitting layer MQW, may reflect most of the light from the light-emitting layer MQW, although the reflective layer RFL is not disposed on the side surface of the reflective electrode layer REL.

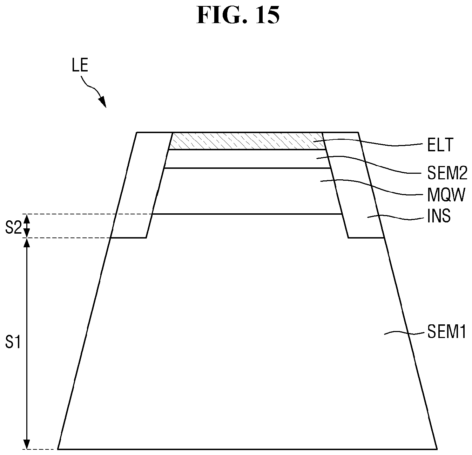

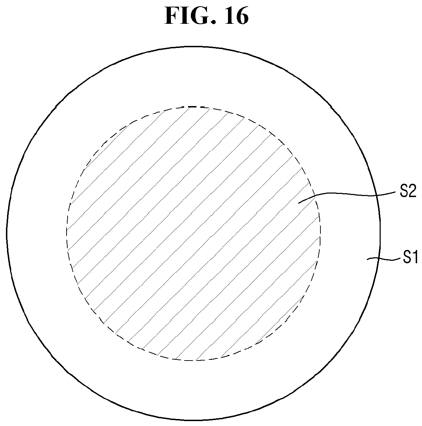

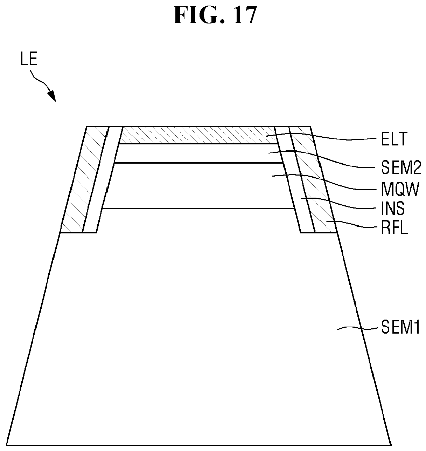

FIG. 15 is a schematic cross-sectional view of a light-emitting element according to another embodiment. FIG. 16 is a schematic plan view illustrating a first semiconductor layer of the light-emitting element of FIG. 15. FIG. 17 is a schematic cross-sectional view of a light-emitting element according to another embodiment.

The embodiments of FIGS. 15 and 16 differ from the embodiments of FIGS. 6 through 14 in that a light-emitting element LE includes a first semiconductor layer SEM1, a light-emitting layer MQW, a second semiconductor layer SEM2, a device electrode layer ELT, and an insulating film INS disposed on the top surface (or upper surface) of the first semiconductor layer SEM1. The embodiments of FIGS. 15 through 17 will hereinafter be described, focusing on the differences with the embodiment of FIGS. 6 through 14 for descriptive convenience.

Referring to FIGS. 15 and 16, the first semiconductor layer SEM1 may include a first portion S1 and a second portion S2, which has a smaller diameter than the first portion S1. The first portion S1 may correspond to most of the first semiconductor layer SEM1 and may correspond to a lower part, in a thickness direction, of the light-emitting element LE. For example, the first portion S1 may be spaced apart from the light-emitting layer MQW, e.g., in a thickness direction of the the first semiconductor layer SEM1. The second portion S2 may be a portion of the first semiconductor layer SEM1 surrounded by the insulating film INS. For example, the first portion S1 may correspond to the entire first semiconductor layer SEM1 except for the second portion S2. The second portion S2 may be a portion of the first semiconductor layer SEM1 in contact with (or adjacent to) the light-emitting layer MQW and may correspond to an upper part, in the thickness direction, of the light-emitting element LE. A step difference may be generated between the first and second portions S 1 and S2 of the first semiconductor layer SEM1 and may provide space in which the insulating film INS is placed.

The width or diameter of the light-emitting layer MQW, the second semiconductor layer SEM2, and the device electrode layer ELT may be smaller than the width or diameter of the first portion S1 of the first semiconductor layer SEM1. For example, the width or diameter of the second portion S2 of the first semiconductor layer SEM1 may be smaller than the width or diameter of the first portion S 1 of the first semiconductor layer SEM1.

The insulating film INS may surround the outer surfaces of portion of the first semiconductor layer SEM1, the light-emitting layer MQW, the second semiconductor layer SEM2, and the device electrode layer ELT. The insulating film INS may surround the outer surfaces of the second portion S2 of the first semiconductor layer SEM1, the light-emitting layer MQW, the second semiconductor layer SEM2, and the device electrode layer ELT. As the insulating film INS surrounds the outer surface of at least the light-emitting layer MQW, the insulating film INS may protect the light-emitting layer MQW from the outside and may prevent any electrical contact with the light-emitting layer MQW.

The insulating film INS may be disposed on the top surface (or upper surface) of the first portion S1 of the first semiconductor layer SEM1 and may be in contact with (e.g., in direct contact with) the top surface (or upper surface) of the first portion S1. The side surface of the second insulating film INS2 may be aligned with the side surface of the first portion S1 of the first semiconductor layer SEM1.

The light-emitting element LE may include the first and second portions S1 and S2, which have different diameters, and the insulating film INS may surround the light-emitting layer MQW. As the insulating film INS is formed as a multilayer film, the degradation of the light-emitting layer MQW may be prevented, and the quantum efficiency and the momentary afterimage of the light-emitting element LE may be improved.

Referring to FIG. 17, the light-emitting element LE may further include a reflective layer RFL, which surrounds the insulating film INS. The side surface of the insulating film INS may not be aligned with the side surface of the first portion S 1 of the first semiconductor layer SEM1.

The reflective layer RFL may be disposed on the top surface (or upper surface) of the first portion S1 of the first semiconductor layer SEM1 and may be in contact with (e.g., in direct contact with) the top surface (or upper surface) of the first portion S1 of the first semiconductor layer SEM1. The side surfaces of the reflective layer RFL and the first portion S1 of the first semiconductor layer SEM1 may be aligned with each other. The top surfaces (or upper surfaces) of the insulating film INS and the reflective layer RFL may be aligned with the top surface (or upper surface) of the device electrode layer ELT.

As the light-emitting element LE further includes the reflective layer RFL, the light output efficiency of the light-emitting element LE may be improved.

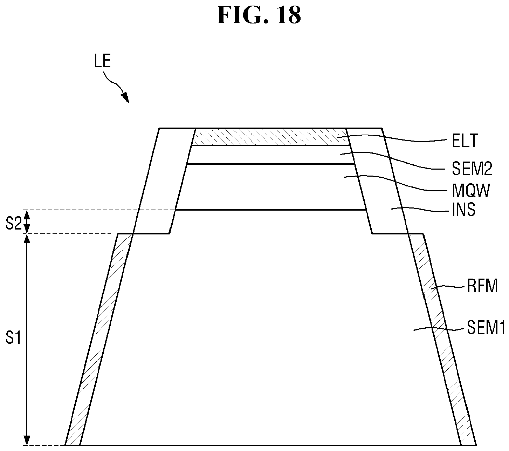

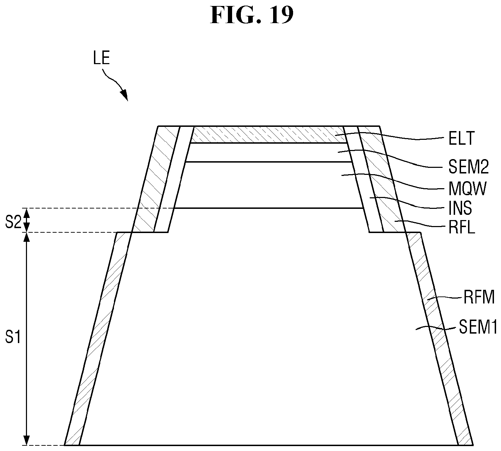

FIGS. 18 and 19 are schematic cross-sectional views of light-emitting elements according to other embodiments.

The embodiments of FIGS. 18 and 19 differ from the embodiment of FIGS. 15 through 17 in that a light-emitting element LE further includes a metal layer RFM, which is disposed on the outer surface of a first portion S1 of a first semiconductor layer SEM1. The embodiments of FIGS. 18 and 19 will hereinafter be described, focusing on the differences with the embodiment of FIGS. 15 through 17 for descriptive convenience.

Referring to FIGS. 18 and 19, the metal layer RFM may surround the outer surface of the first semiconductor layer SEM1. The metal layer RFM may surround the outer surface of the first portion S 1 of the first semiconductor layer SEM1. The metal layer RFM may be spaced apart from an insulating film INS or a reflective layer RFL, which is disposed on the first semiconductor layer SEM1.

The metal layer RFM may include a metal with high reflectance and may reflect light, emitted from a light-emitting layer MQW, to the outside. The metal layer RFM may be formed as, for example, a single layer or a multilayer including Ag, Cu, Al, Ti, or Ni.

As the light-emitting element LE further includes the metal layer RFM, which surrounds the first portion S 1 of the first semiconductor layer SEM1, the light output efficiency of the light-emitting element LE may be improved.

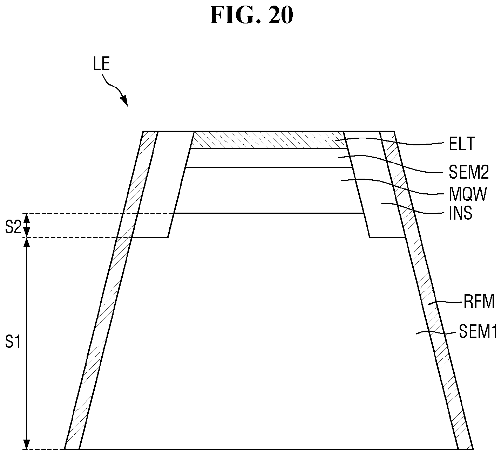

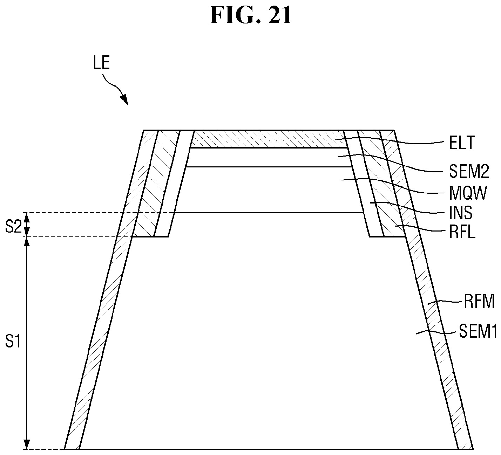

FIGS. 20 and 21 are schematic cross-sectional views of light-emitting elements according to other embodiments.

The embodiments of FIGS. 20 and 21 differ from the embodiments of FIGS. 19 and 20 in that a metal layer RFM further surrounds the outer surface of an insulating film INS or a reflective layer RFL. The embodiments of FIGS. 20 and 21 will hereinafter be described, focusing on the differences with the embodiments of FIGS. 20 and 21 for descriptive convenience.

Referring to FIGS. 20 and 21, the metal layer RFM may surround the outer surface of the insulating film INS. The metal layer RFM may surround the outer surface of a first portion S1 of a first semiconductor layer SEM1 or the outer surface of the insulating film INS. For example, the metal layer RFM may surround the outer surface of the reflective layer RFL. The metal layer RFM may surround the outer surface of the first portion S 1 of the first semiconductor layer SEM1 and the outer surface of the reflective layer RFL. For example, the metal layer RFM may surround the entire light-emitting element LE except for the upper and lower end portions of the light-emitting element LE.

As a light-emitting element LE includes the metal layer RFM, which surrounds not only the first portion S 1 of the first semiconductor layer SEM1, but also the insulating film INS or the reflective layer RFL, the light output efficiency of the light-emitting element LE may be further improved.

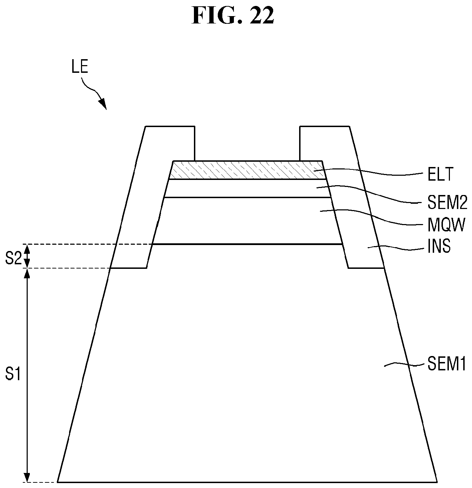

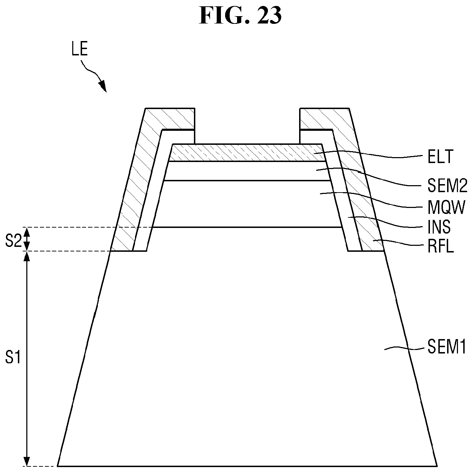

FIGS. 22 and 23 are schematic cross-sectional views of light-emitting elements according to other embodiments.

The embodiments of FIGS. 22 and 23 differ from the embodiments of FIGS. 15 through 17 in that an insulating film INS or both the insulating film INS and a reflective layer RFL cover the top surface (or upper surface) of a device electrode layer ELT. The embodiments of FIGS. 22 through 23 will hereinafter be described, focusing on the differences with the embodiments of FIGS. 15 through 17 for descriptive convenience.

Referring to FIG. 22, the insulating film INS may surround the outer surfaces of a second portion S2 of a first semiconductor layer SEM1, a light-emitting layer MQW, a second semiconductor layer SEM2, and the device electrode layer ELT. For example, the insulating film INS may cover portion of the top surface (or upper surface) of the device electrode layer ELT. The insulating film INS may cover the edge of the top surface (or upper surface) of the device electrode layer ELT and may expose portion of the device electrode layer ELT.

In a case where the insulating film INS covers the edge of the top surface (or upper surface) of the device electrode layer ELT, the thickness of the insulating film INS may be uniformly maintained during the formation of the insulating film INS. For example, the thickness of portion of the insulating film INS on the top surface (or upper surface) of the device electrode layer ELT and the thickness of portion of the insulating film INS covering the outer surface of the device electrode layer ELT may be the same as each other. Accordingly, the light-emitting layer MQW, which is surrounded by the insulating film INS, may be protected from the outside, and the degradation of the light-emitting layer MQW may be prevented. For example, the insulating film INS may insulate the device electrode layer ELT from other neighboring electrodes.

Referring to FIG. 23, the reflective layer RFL may be disposed on the insulating film INS. The reflective layer RFL may be disposed on the top surface (or upper surface) of a first portion S 1 of the first semiconductor layer SEM1 to surround the side surface of the insulating film INS and may cover the top surface (or upper surface) of the insulating film INS. The reflective layer RFL may also cover the top surface (or upper surface) of the device electrode layer ELT, together with the insulating film INS. The reflective layer RFL may overlap the top surface (or upper surface) of the device electrode layer ELT in a thickness direction. The side surface of the reflective layer RFL may be aligned with the side surface of the first portion S1 of the first semiconductor layer SEM1. The side surfaces of the insulating film INS and the reflective layer RFL may be aligned with each other on the device electrode layer ELT.

As the reflective layer RFL covers the top surface (or upper surface) of the device electrode layer ELT and the outer surface of a light-emitting layer MQW, light emitted from the light-emitting layer MQW may be reflected toward the first semiconductor layer SEM1. Accordingly, the light output efficiency of a light-emitting element LE may be improved.

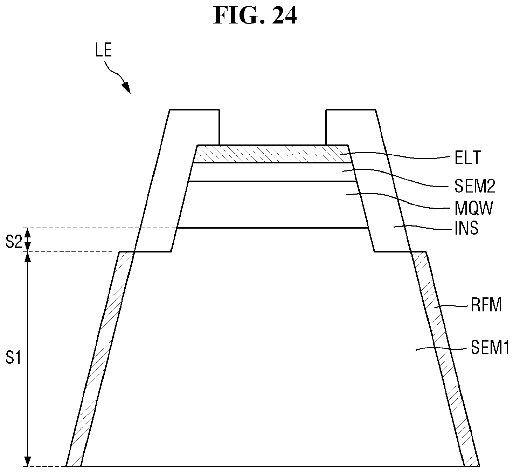

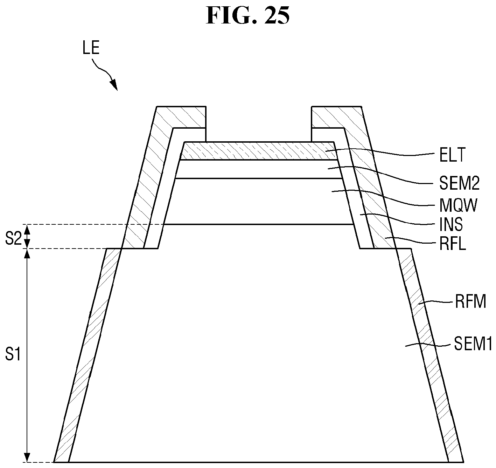

FIGS. 24 and 25 are schematic cross-sectional views of light-emitting elements according to other embodiments.

The embodiments of FIGS. 24 and 25 differ from the embodiments of FIGS. 22 and 23 in that a metal layer RFM, which is disposed on the outer surface of a first portion S1 of a first semiconductor layer SEM1, is further provided. The embodiments of FIGS. 24 through 25 will hereinafter be described, focusing on the differences with the embodiments of FIGS. 22 and 23 for descriptive convenience.

Referring to FIGS. 24 and 25, the metal layer RFM may surround the outer surface of the first semiconductor layer SEM1. The metal layer RFM may surround the outer surface or the side surface of the first portion S 1 of the first semiconductor layer SEM1. The metal layer RFM may be spaced apart from an insulating film INS or a reflective layer RFL, which is disposed on the first semiconductor layer SEM1, and may not be in contact with the side surface of the insulating film INS.

The metal layer RFM may include a metal with high reflectance and may reflect light, emitted from a light-emitting layer MQW, to the outside. The metal layer RFM may be formed as, for example, a single layer or a multilayer including Ag, Cu, Al, Ti, or Ni.

As a light-emitting element LE further includes the metal layer RFM, which surrounds the first portion S1 of the first semiconductor layer SEM1, the light output efficiency of the light-emitting element LE may be improved.

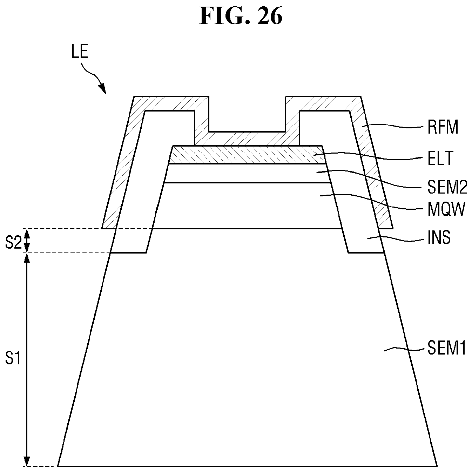

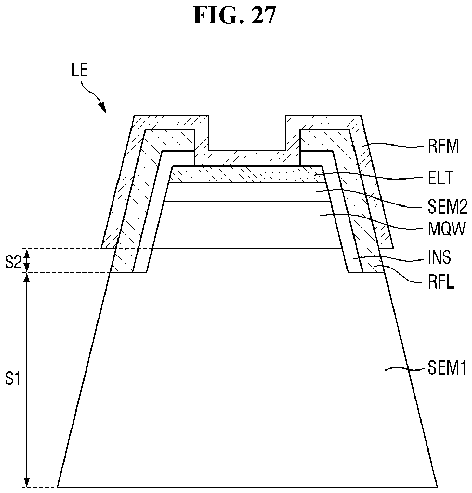

FIGS. 26 and 27 are schematic cross-sectional views of light-emitting elements according to other embodiments.

The embodiments of FIGS. 26 and 27 differ from the embodiments of FIGS. 22 and 23 in that a metal layer RFM is further disposed on an insulating film INS or a reflective layer RFL. The embodiments of FIGS. 26 through 27 will hereinafter be described, focusing on the differences with the embodiments of FIGS. 22 and 23 for descriptive convenience.

Referring to FIG. 26, the metal layer RFM may be disposed on the insulating film INS and a device electrode layer ELT. The metal layer RFM may be in contact with (e.g., in direct contact with) the side surface and the top surface (or upper surface) of the insulating film INS and with the top surface (or upper surface) of the device electrode layer ELT. The metal layer RFM may function as a reflective layer. For example, as the metal layer RFM has conductivity, the metal layer RFM may transmit electrical signals to the device electrode layer ELT. For example, as the metal layer RFM functions as a reflective electrode layer, a separate reflective electrode layer may not be provided.

The metal layer RFM may surround portion of the outer surface of the insulating film INS. As the metal layer RFM is conductive, the metal layer RFM may be spaced apart from the first semiconductor layer SEM1, and may not be electrically connected to the first semiconductor layer SEM1. The metal layer RFM may be disposed at the interface between a light-emitting layer MQW and the first semiconductor layer SEM1 and may thus reflect light, emitted from the light-emitting layer MQW, to the first semiconductor layer SEM1.

Referring to FIG. 27, the metal layer RFM may be disposed (e.g., directly disposed) on the reflective layer RFL and the device electrode layer ELT. The metal layer RFM may be in contact with (e.g., in direct contact with) the side surface and the top surface (or upper surface) of the reflective layer RFL and with the top surface (or upper surface) of the device electrode layer ELT. The metal layer RFM may surround portion of the outer surface of the reflective layer RFL. The metal layer RFM may surround the side surface of the light-emitting layer MQW, on the side surface of the reflective layer RFL. As the metal layer RFM is spaced apart from the first semiconductor layer SEM1 and is disposed at the interface between the light-emitting layer MQW and the first semiconductor layer SEM1, the metal layer RFM may reflect light, emitted from the light-emitting layer MQW, to the first semiconductor layer SEM1.

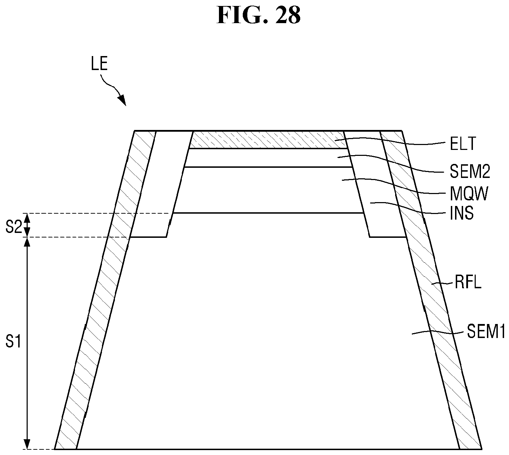

FIG. 28 is a schematic cross-sectional view of a light-emitting element according to another embodiment.

The embodiment of FIG. 28 differs from the embodiment of FIG. 15 in that a light-emitting element LE further includes a reflective layer RFL, which surrounds the outer surfaces of an insulating film INS and a first semiconductor layer SEM1. The embodiment of FIG. 28 will hereinafter be described, focusing on the differences with the embodiment of FIG. 15 for descriptive convenience.

Referring to FIG. 28, the reflective layer RFL may surround the outer surfaces of the insulating film INS and the first semiconductor layer SEM1. For example, the reflective layer RFL may be in contact with (e.g., in direct contact with) the side surface of the insulating film INS and may be in contact with (e.g., in direct contact with) the side surface of a first portion S1 of the first semiconductor layer SEM1. The top surface (or upper surface) of the reflective layer RFL may be aligned with the top surface (or upper surface) of the insulating film INS, and the bottom surface (or lower surface) of the reflective layer RFL may be aligned with the bottom surface (or lower surface) of the first semiconductor layer SEM1.

As the reflective layer RFL surrounds the outer surfaces of the insulating film INS and the first semiconductor layer SEM1, which form the outer surface of the light-emitting element LE, the light output efficiency of the light-emitting element LE may be further improved.

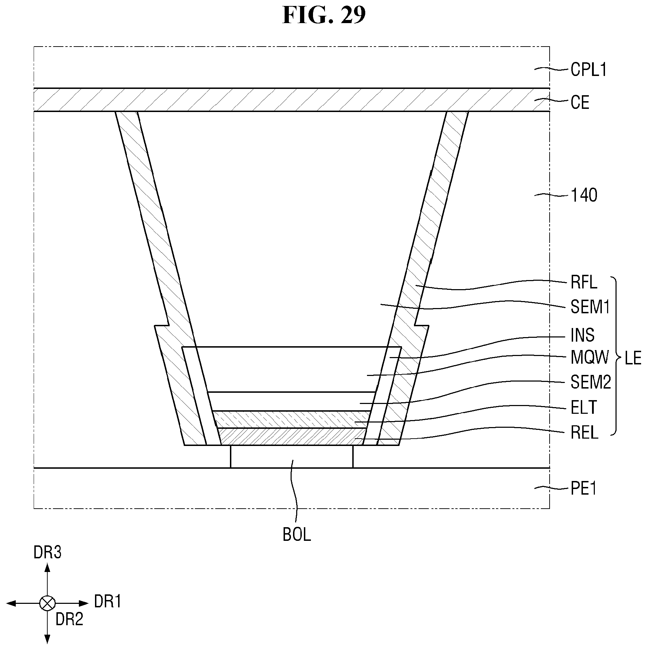

FIG. 29 is a schematic cross-sectional view of a display device according to another embodiment.

FIG. 29 illustrates a first pixel electrode PE1, a light-emitting element LE, and a common electrode CE in a first emission area EA1 (see, e.g., FIG. 6) of a display device according to another embodiment, and the display device of FIG. 29 has a different structure from the display device of FIG. 13.

The embodiment of FIG. 29 differs from the embodiment of FIG. 13 in that an insulating film INS surrounds the outer surfaces of a light-emitting layer MQW, a second semiconductor layer SEM2, a device electrode layer ELT, and a reflective electrode layer REL, and that the reflective layer RFL surrounds the outer surfaces of the insulating film INS and the first semiconductor layer SEM1. The display device of FIG. 29 will hereinafter be described, focusing on the differences with the display device of FIG. 13 for descriptive convenience.

Referring to FIG. 29, the insulating film INS may surround the outer surfaces of the light-emitting layer MQW, the second semiconductor layer SEM2, the device electrode layer ELT, and the reflective electrode layer REL. The insulating film INS may surround the side surfaces of the light-emitting layer MQW, the second semiconductor layer SEM2, the device electrode layer ELT, and the reflective electrode layer REL, but not the outer surface of the first semiconductor layer SEM1. As the insulating film INS surrounds the outer surface of the light-emitting layer MQW, the insulating film INS may protect the light-emitting layer MQW from the outside and may prevent the degradation of the light-emitting layer MQW.

The reflective layer RFL may surround the outer surface of the insulating film INS. The reflective layer RFL may surround the outer surfaces of the first semiconductor layer SEM1 and the insulating film INS. For example, the reflective layer RFL may surround an entire light-emitting element LE except for the upper end portions and the lower end portions of the light-emitting element LE.

The display device of FIG. 29 may be fabricated as follows. The light-emitting element LE with the insulating film INS, which surrounds the outer surfaces of the light-emitting layer MQW, the second semiconductor layer SEM2, the device electrode layer ELT, and the reflective electrode layer REL may be bonded onto the first pixel electrode PE1. For example, an organic layer such as a photoresist layer may be formed to expose portion of the insulating film INS. Thereafter, the exposed portion of the insulating film INS may be removed, and the organic layer may be removed. Thereafter, the reflective layer RFL may surround the insulating film INS and the first semiconductor layer thereby implementing the display device of FIG. 29.

As the insulating film INS surrounds the outer surface of at least the light-emitting layer MQW and the reflective layer RFL is disposed on the outer surfaces of the insulating film INS and the first semiconductor layer the degradation of the light-emitting layer MQW may be prevented, and the light output efficiency of the light-emitting element LE may be improved.

An organic layer 140, which surrounds the light-emitting element LE, may have the same height as the light-emitting element LE. The top surface (or upper surface) of the organic layer 140 may be aligned with the top surface (or upper surface) of the first semiconductor layer SEM1. However, embodiments are not limited to this. In another example, the height of the organic layer 140 may be less than the height of the light-emitting element LE.

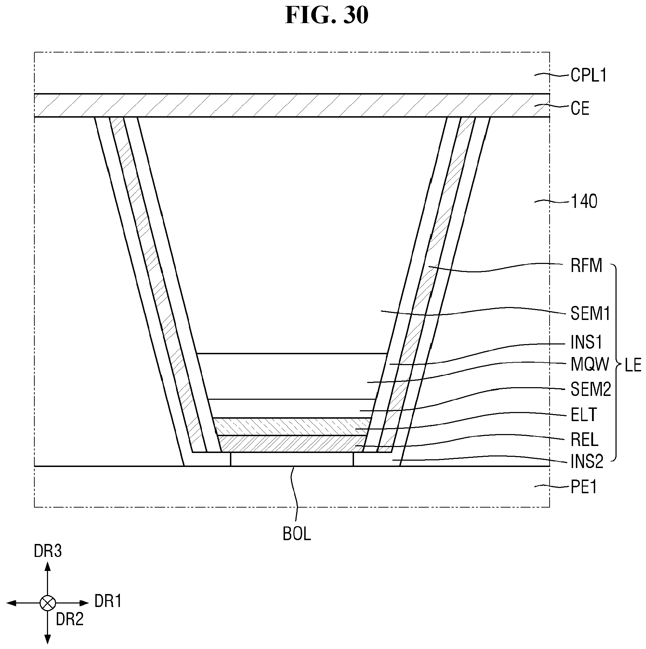

FIG. 30 is a schematic cross-sectional view of a display device according to another embodiment.

The embodiment of FIG. 30 differs from the embodiment of FIG. 29 in that a first insulating film INS1 surrounds the outer surfaces of a first semiconductor layer a light-emitting layer MQW, a second semiconductor layer SEM2, a device electrode layer ELT, and a reflective electrode layer REL, that a metal layer RFM surrounds the outer surface of the first insulating film INS1, and that a second insulating film INS2 surrounds the metal layer RFM. The embodiment of FIG. 30 will hereinafter be described, focusing on the differences with the embodiment of FIG. 29 for descriptive convenience.

Referring to FIG. 30, the first insulating film INS1 may surround the outer surfaces of the first semiconductor layer the light-emitting layer MQW, the second semiconductor layer SEM2, the device electrode layer ELT, and the reflective electrode layer REL. The metal layer RFM may surround the outer surface of the insulating film INS. The first insulating film INS1 may insulate the first semiconductor layer the light-emitting layer MQW, the second semiconductor layer SEM2, the device electrode layer ELT, and the reflective electrode layer REL from the metal layer RFM.

The bottom surface (or lower surface) of the first insulating film INS1 and the bottom surface (or lower surface) of the metal layer RFM may be aligned (or coplanar) with the bottom surface (or lower surface) of the reflective electrode layer REL. The top surface (or upper surface) of the first insulating film INS1 and the top surface (or upper surface) of the metal layer RFM may be aligned (or coplanar) with the top surface (or upper surface) of the first semiconductor layer SEM1.

The second insulating film INS2 may surround the outer surface of the metal layer RFM and cover the bottom surfaces (or lower surfaces) of the first insulating film INS1 and the metal layer RFM. The second insulating film INS2 may insulate the metal layer RFM from the outside. The second insulating film INS2 may cover portion of the bottom surface (or lower surface) of the reflective electrode layer REL and may be in contact with (e.g., in direct contact with) a connecting electrode BOL, but embodiments are not limited thereto. In another example, the second insulating film INS2 may be spaced apart from the reflective electrode layer REL and the connecting electrode BOL.

As the metal layer RFM reflects light emitted from the light-emitting layer MQW, the light output efficiency of a light-emitting element LE may be improved. As the first and second insulating films INS1 and INS2 insulate the metal layer RFM, defects in the light-emitting element LE may be prevented.

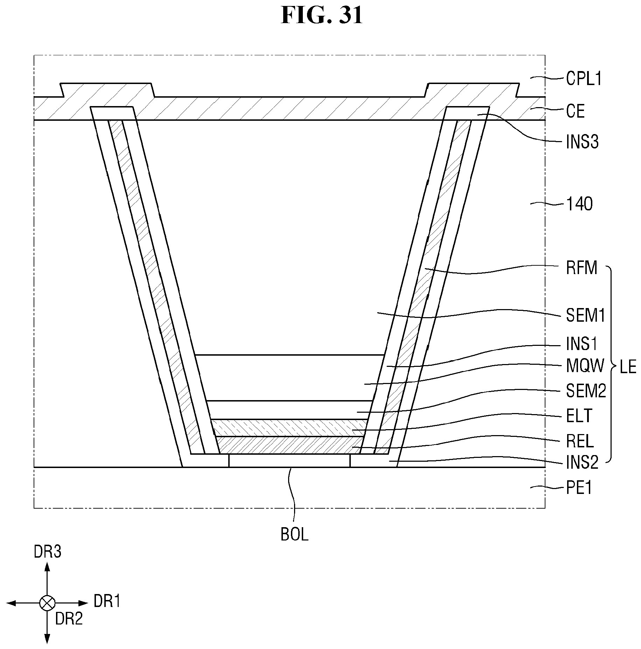

FIG. 31 is a schematic cross-sectional view of a display device according to another embodiment.

The embodiment of FIG. 31 differs from the embodiment of FIG. 30 in that it further includes a third insulating film INS3, which covers the top surfaces (or upper surfaces) of a first insulating film INS1 and a metal layer RFM. The embodiment of FIG. 31 will hereinafter be described, focusing on the differences with the embodiment of FIG. 30 for descriptive convenience.

Referring to FIG. 31, the third insulating film INS3 may be disposed on the light-emitting element LE. The third insulating film INS3 may cover the top surfaces (or upper surfaces) of the first insulating film INS1, the metal layer RFM, and a second insulating film INS2 of the light-emitting element LE and may be in contact with (e.g., in direct contact with) the first insulating film INS1, the metal layer RFM, and a second insulating film INS2 of the light-emitting element LE. The third insulating film INS3 may be disposed between the metal layer RFM and a common electrode CE and may insulate the top surface (or upper surface) of the metal layer RFM such that the metal layer RFM may not be electrically connected to the common electrode CE.

FIG. 31 illustrates that the third insulating film INS3 is disposed on the top surfaces (or upper surfaces) of the first insulating film INS1, the metal layer RFM, and the second insulating film INS2, but embodiments are not limited thereto. In another example, the third insulating film INS3 may be disposed at least on the top surface (or upper surface) of the metal layer RFM. For example, the third insulating film INS3 may be disposed only on the top surface (or upper surface) of the metal layer RFM, on the top surfaces (or upper surface) of the metal layer RFM and the first insulating film INS1, or on the top surfaces (or upper surfaces) of the metal layer RFM and the second insulating film INS2.

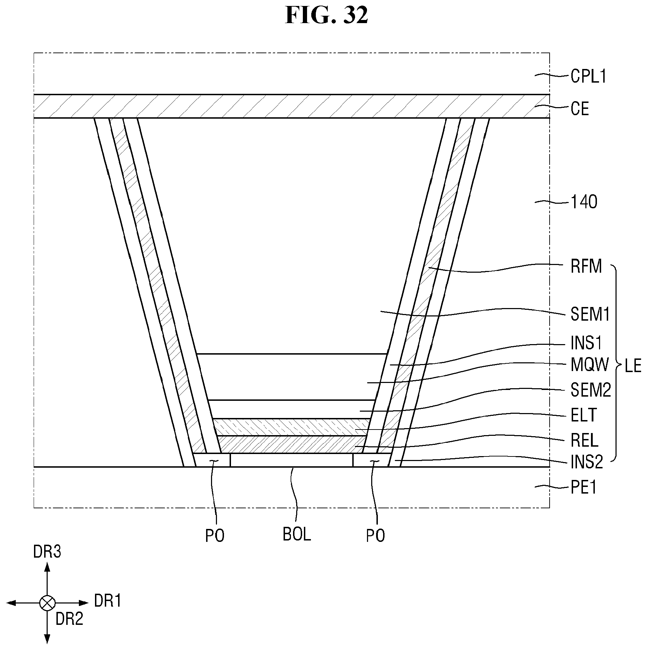

FIG. 32 is a schematic cross-sectional view of a display device according to another embodiment.

The embodiment of FIG. 32 differs from the embodiment of FIG. 30 in that a second insulating film INS2 is not disposed on the bottom surfaces (or lower surfaces) of a first insulating film INS1 and a metal layer RFM, but extends to the top surface (or upper surface) of a first pixel electrode PE1. The embodiment of FIG. 32 will hereinafter be described, focusing on the differences with the embodiment of FIG. 30 for descriptive convenience.

Referring to FIG. 32, the second insulating film INS2 may surround the outer surface of the metal layer RFM and extend to the top surface (or upper surface) of the first pixel electrode PE1. The second insulating film INS2 may be in contact with (e.g., in direct contact with) the top surface (or upper surface) of the first pixel electrode PE1. The second insulating film INS2 may not be in contact with the bottom surfaces (or lower surfaces) of the first insulating film INS1 and the metal layer RFM and may be spaced apart from the bottom surfaces (or lower surfaces) of the first insulating film INS 1 and the metal layer RFM. As the second insulating film INS2 is formed by a deposition process after the bonding of a light-emitting element LE to the first pixel electrode PE1, the second insulating film INS2 may extend to the first pixel electrode PE1.

A gap (e.g., empty space which is filled with air or gas) PO may be disposed between the second insulating film INS2 and a connecting electrode BOL. As the second insulating film INS2 is in contact with the first pixel electrode PE1, surrounding the connecting electrode BOL, the gap (e.g., empty space) PO may be disposed in an area surrounded by the second insulating film INS2.

As the second insulating film INS2 is formed after the bonding of the light-emitting element LE to the first pixel electrode PE1, the metal layer RFM may be insulated.

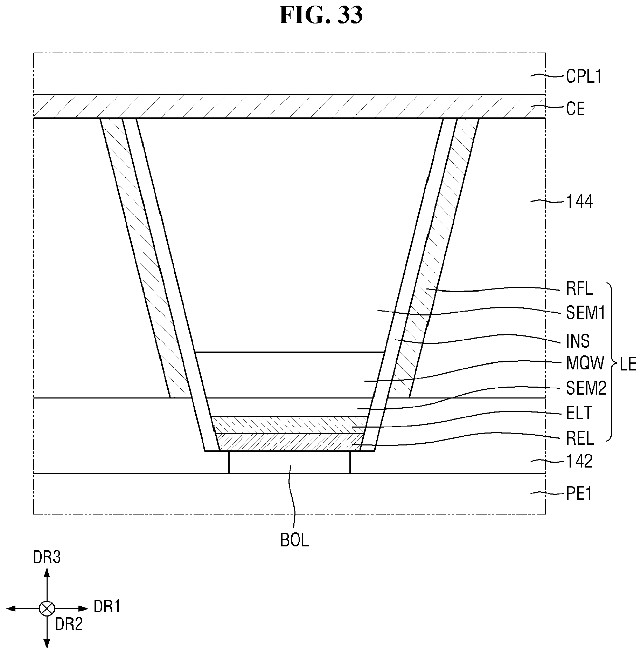

FIG. 33 is a schematic cross-sectional view of a display device according to another embodiment.

The embodiment of FIG. 33 differs from the embodiment of FIG. 30 in that in a light-emitting element LE, a reflective layer RFL covers portion of the outer surface of an insulating film INS, and that first and second organic layers 142 and 144 are disposed near the light-emitting element LE. The embodiment of FIG. 33 will hereinafter be described, focusing on the differences with the embodiment of FIG. 30 for descriptive convenience.

Referring to FIG. 33, the first organic layer 142 may be disposed on a first pixel electrode PE1 where the light-emitting element LE is disposed. Portion of the light-emitting element LE may be inserted in the first organic layer 142, and the first organic layer 142 may surround the light-emitting element LE. For example, the first organic layer 142 may surround a second semiconductor layer SEM2, a device electrode layer ELT, and a reflective electrode layer REL of the light-emitting element LE and portion of the insulating film INS of the light-emitting element LE. The top surface (or upper surface) of the first organic layer 142 may be aligned with the top surface (or upper surface) of the second semiconductor layer SEM2 of the light-emitting element LE.

The reflective layer RFL may be disposed on the first organic layer 142. The reflective layer RFL may surround portion of the outer surface of the insulating film INS of the light-emitting element LE. The reflective layer RFL may extend from the top surface (or upper surface) of the first organic film 142 to the outer surface of the insulating film INS. The bottom surface (or lower surface) of the reflective layer RFL may be aligned with the bottom surface (or lower surface) of a light-emitting layer MQW. For example, the reflective layer RFL may surround the side surface of at least the light-emitting layer MQW, on the outer surface of the insulating film INS, and may improve the light output efficiency of the light-emitting element LE by reflecting light emitted from the light-emitting layer MQW. The reflective layer RFL may be formed by being deposited and etched on the first organic layer 142 and the light-emitting element LE.

The second organic layer 144 may be disposed on the first organic layer 142. The second organic layer 144 may be in contact with the outer surface of the reflective layer RFL, and the top surface (or upper surface) of the second organic layer 144 may be aligned with the top surface (or upper surface) of the light-emitting element LE. The second organic layer 144 may planarize the step differences below a common electrode CE.

As the reflective layer RFL reflects light emitted from the light-emitting layer MQW, the light output efficiency of the light-emitting element LE may be improved.

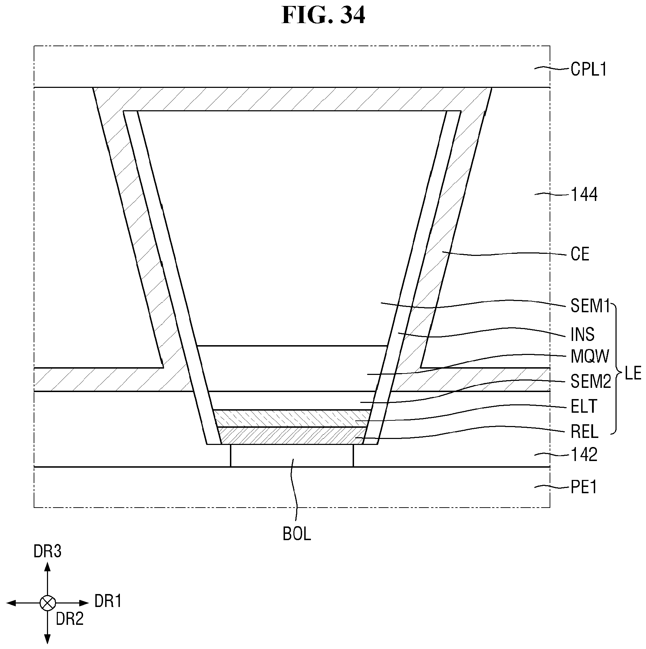

FIG. 34 is a schematic cross-sectional view of a display device according to another embodiment.

The embodiment of FIG. 34 differs from the embodiment of FIG. 33 in that a common electrode CE surrounds a light-emitting element LE and is positioned on a first organic layer 142. The embodiment of FIG. 34 will hereinafter be described, focusing on the differences with the embodiment of FIG. 33 for descriptive convenience.

Referring to FIG. 34, the first organic layer 142 may be disposed on a first pixel electrode PE1 where the light-emitting element LE is disposed. The common electrode CE may be disposed on the light-emitting element LE and the first organic layer 142. The common electrode CE may surround the outer surface of an insulating film INS of the light-emitting element LE and may be in contact with (e.g., in direct contact with) a first semiconductor layer SEM1 of the light-emitting element LE. The common electrode CE may include a metal with high reflectance and may thus function not only as an electrode, but also as a reflective layer. The common electrode CE may surround at least a light-emitting layer MQW of the light-emitting element LE and may thus reflect light emitted from the light-emitting layer MQW. As the common electrode CE functions as a reflective layer, a separate reflective layer may not be provided.

A second organic layer 144 may be disposed on the common electrode CE. The top surface (or upper surface) of the second organic layer 144 may be aligned with the top surface of the common electrode CE. A first capping layer CPL1 may be disposed on the common electrode CE and the second organic layer 144.

A method of manufacturing a display device according to some embodiments of disclosure will hereinafter be described.

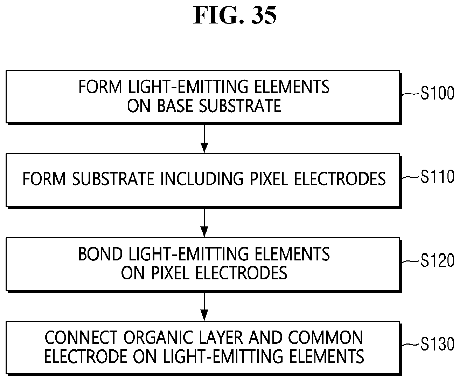

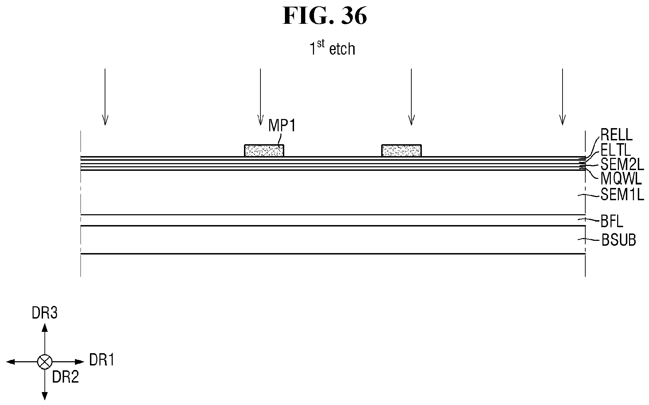

FIG. 35 is a flowchart illustrating a method of fabricating a display device according to an embodiment. FIGS. 36 through 52 are schematic cross-sectional views illustrating the method of FIG. 35.

FIGS. 36 through 52 illustrate how to form layers of a display device 10, e.g., how to fabricate a light-emitting element unit LEP of the display device 10, and the cross-sectional views of FIGS. 36 through 52 may correspond to the schematic cross-sectional view of FIG. 6. First and second emission areas EA1 and EA2 of the display device 10 are illustrated in FIGS. 36 through 52. A method of fabricating the display device 10 will hereinafter be described with reference to FIGS. 35 through 52.

Referring to FIG. 35, the method may include forming light-emitting elements on a base substrate (S 100), forming a substrate including pixel electrodes (S110), bonding the light-emitting elements onto the pixel electrodes (S120), and connecting an organic layer and a common electrode to the light-emitting elements (S130).

Referring to FIG. 36, light-emitting elements LE may be formed on a base substrate BSUB.

For example, the base substrate BSUB may be prepared. The base substrate BSUB may be a sapphire (Al₂O₃) substrate or a Si wafer, but embodiments are not limited thereto. The base substrate BSUB will hereinafter be described as being a sapphire substrate.

Semiconductor material layers, e.g., a buffer layer BFL, a first semiconductor material layer SEM1L, a light-emitting material layer MQML, and a second semiconductor material layer SEM2L, may be formed on the base substrate BSUB. The semiconductor material layers may be formed by growing seed crystals. For example, the semiconductor material layers may be formed by electron beam deposition, physical vapor deposition (PVD), chemical vapor deposition (CVD), plasma laser deposition, dual-type thermal evaporation, sputtering, or metal-organic chemical vapor deposition (MOCVD), but embodiments are not limited thereto.

Precursor materials for forming the semiconductor material layers are not limited in embodiments. For example, the precursor materials may be metal precursors including an alkyl group such as a methyl or ethyl group. For example, the precursor materials may be compounds such as trimethyl gallium (Ga(CH₃)₃), trimethyl aluminum (Al(CH₃)₃), or triethyl phosphate ((C₂H₅)₃PO₄), but embodiments are not limited thereto.

The buffer layer BFL may be formed on the base substrate BSUB. One buffer layer BFL may be formed on the base substrate BSUB, but embodiments are not limited thereto. In another example, more than one buffer layer BFM may be formed on the base substrate BSUB. The buffer layer BFL may be disposed to reduce the difference in lattice constant between the first semiconductor material layer SEM1L and the base substrate BSUB. For example, the buffer layer BFL may include an undoped semiconductor, which is not doped with an n-type dopant or a p-type dopant. The buffer layer BFL may include at least one of InAlGaN, GaN, AlGaN, InGaN, AlN, and InN that are not doped, but embodiments are not limited thereto.

Thereafter, the first semiconductor material layer SEM1L, the light-emitting material layer MQWL, and the second semiconductor material layer SEM2L are sequentially formed on the buffer layer BFL.

Thereafter, a device electrode material layer ELTL and a reflective electrode material layer RELL are sequentially stacked on the second semiconductor material layer SEM2L.

Thereafter, first mask patterns MP1 may be formed on the reflective electrode material layer RELL. The first mask patterns MP1 may be hard mask patterns including an inorganic material or photoresist mask patterns including an organic material. The first mask patterns MP1 may prevent the second semiconductor material layer SEM2L, the light-emitting material layer MQML, the first semiconductor material layer SEM1L, the device electrode material layer ELTL, and the reflective electrode material layer RELL from being etched. Thereafter, light-emitting elements LE may be formed by performing a first etching process ("1^{st} etch") to etch parts of the semiconductor material layers using the first mask patterns MP1 as a mask.

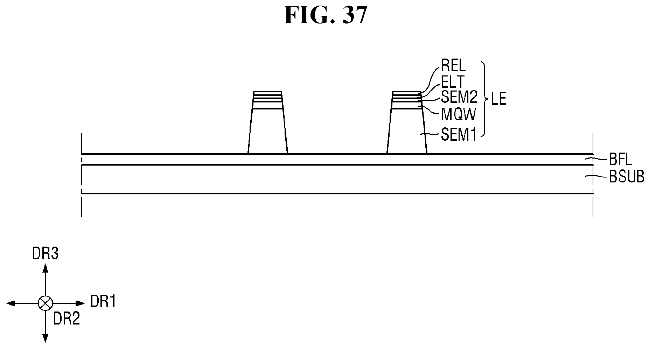

Referring to FIG. 37, parts of the second semiconductor material layer SEM2L, the light-emitting material layer MQML, the first semiconductor material layer SEM1L, the device electrode material layer ELTL, and the reflective electrode material layer RELL that do not overlap the first mask patterns MP1 may be etched away. For example, parts of the second semiconductor material layer SEM2L, the light-emitting material layer MQML, the first semiconductor material layer SEM1L, the device electrode material layer ELTL, and the reflective electrode material layer RELL, which overlap the first mask patterns MP1 and are thus not etched away, may form the light-emitting elements LE.

The semiconductor material layers may be etched by a typical method. For example, the semiconductor material layers may be etched by a dry etching method, a wet etching method, a reactive ion etching (RIE) method, a deep reactive ion etching (DRIE) method, or an inductively coupled plasma (ICP-RIE) method. As the dry etching method includes an anisotropic etching process, the dry etching method may be suitable for a vertical etching process. During the etching process on the semiconductor material layers, Cl₂ or O₂ may be used as an etchant, but embodiments are not limited thereto.

The parts of the second semiconductor material layer SEM2L, the light-emitting material layer MQML, the first semiconductor material layer SEM1L, the device electrode material layer ELTL, and the reflective electrode material layer RELL that are not etched away may form the light-emitting elements LE. Thus, the light-emitting elements LE may include first semiconductor layers light-emitting layers MQW, second semiconductor layers SEM2, device electrode layers ELT, and reflective electrode layers REL.

Thereafter, an insulating material layer INSL may be formed on the base substrate BSUB where the light-emitting elements LE are formed.

For example, the insulating material layer INSL may be formed on the outer surfaces of each of the light-emitting elements LE. The insulating material layer INSL may be formed on the entire surface of the base substrate BSUB, e.g., not only on the light-emitting elements LE, but also on parts of the top surface (or upper surface) of the buffer layer BFL exposed by the light-emitting elements LE.

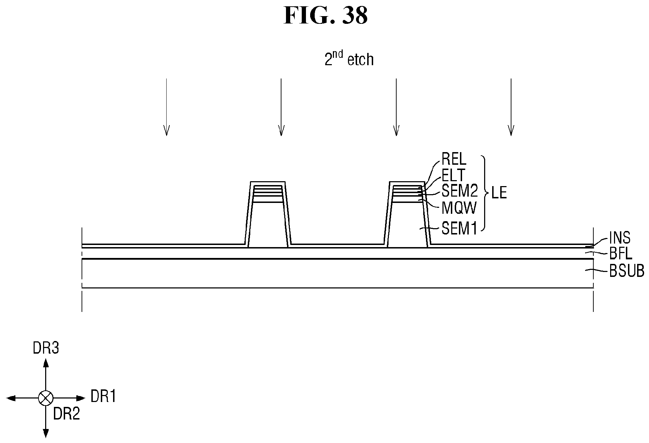

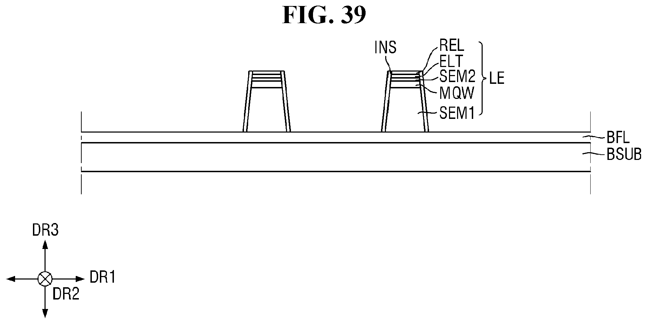

Thereafter, referring to FIGS. 38 and 39, light-emitting elements LE including insulating films INS may be formed by performing a second etching process ("2^{nd} etch") to partially remove the insulating material layer INSL.

For example, the second etching process may be performed such that the insulating material layer INSL may expose the top surfaces (or upper surfaces) of the light-emitting elements LE, but may surround the side surfaces of the light-emitting elements LE. The insulating material layer INSL may be partially removed to expose the top surfaces (or upper surfaces) of the reflective electrode layers REL of the light-emitting elements LE. The removal of the insulating material layer INSL may be performed by a dry etching process or an etch-back process, which is an anisotropic etching process.

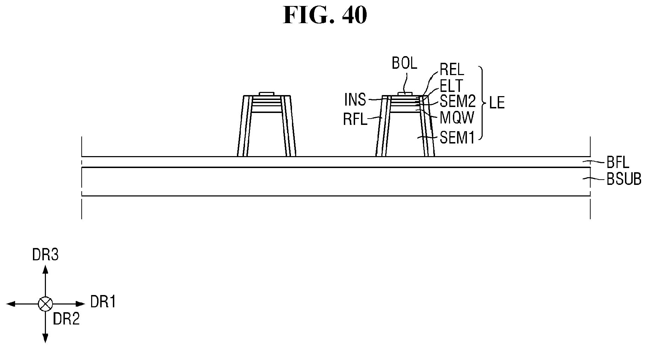

Thereafter, referring to FIG. 40, reflective layers RFL, which surround the insulating films INS of the light-emitting elements LE, may be formed, and connecting electrodes BOL may be formed on the reflective electrode layers REL of the light-emitting elements LE.

For example, the reflective layers RFL and the insulating films INS may be formed in the same manner. For example, one or more reflective material layers may be stacked on the base substrate BSUB, and the reflective layers RFL, which surround the insulating films INS, may be formed by an etching process.

The connecting electrodes BOL may be formed on the reflective electrode layers REL by stacking an electrode material layer on the base substrate BSUB and etching the electrode material layer.

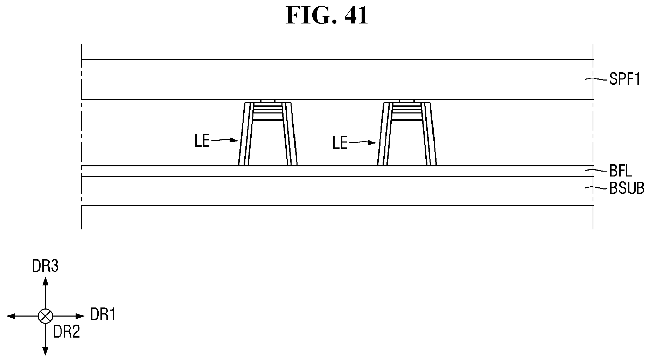

Thereafter, referring to FIG. 41, a first support film SPF1 may be attached on the light-emitting elements LE on the base substrate BSUB.

For example, the first support film SPF1 may be attached on the light-emitting elements LE. The first support film SPF1 may be aligned on the light-emitting elements LE and may be attached on the connecting electrodes BOL of the light-emitting elements LE.
As a large number of light-emitting elements LE are disposed, the light-emitting elements LE may be properly attached to the first support film SPF1, rather than being detached from the first support film SPF1.

The first support film SPF1 may include a support layer and an adhesive layer on the support layer. The support layer may be formed of a transparent material capable of transmitting light therethrough and having mechanical stability. For example, the support layer may include a transparent polymer such as polyester, polyacrylic, polyepoxy, polyethylene, polystyrene, or polyethylene terephthalate. The adhesive layer may include an adhesive material for bonding the light-emitting elements LE. For example, the adhesive material may include urethane acrylate, epoxy acrylate, or polyester acrylate. The adhesive material may be a material whose adhesiveness changes upon exposure to ultraviolet (UV) light or heat, and the adhesive layer may be readily separable from the light-emitting elements LE.

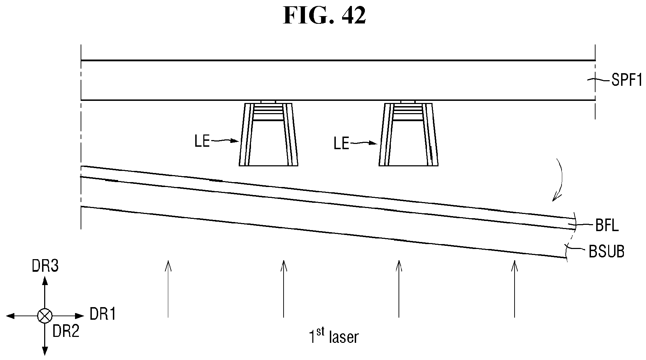

Thereafter, referring to FIG. 42, the base substrate BSUB and the buffer layer BFL may be separated by applying first laser light "1^{st} laser" to the base substrate BSUB. The buffer layer BFL may be separated from the first semiconductor layers SEM1 of the light-emitting elements LE.

The separation of the buffer layer BFL may be performed by a laser liftoff (LLO) process. The LLO process, which is a process using laser light, uses KrF excimer laser having a wavelength of about 248 nm as a source. Excimer laser light may be applied to an incident area of about 50×50 µm² to about 1×1 cm² at an energy density of about 550 mJ/cm² to about 950 m**J**/cm², but embodiments are not limited thereto. As laser light is applied to the buffer layer BFL, the buffer layer BFL may be separated from the light-emitting elements LE.

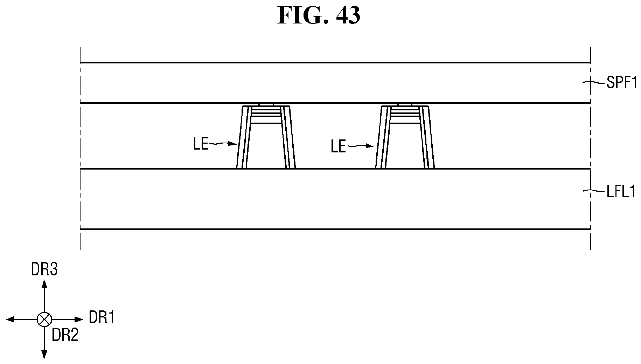

Thereafter, referring to FIG. 43, a first transfer film LFL1 may be attached to the light-emitting elements LE with the base substrate BSUB and the buffer layer BFL separated therefrom.

For example, the first transfer film LFL1 may be attached on the first semiconductor layers SEM1 of the light-emitting elements LE. The first transfer film LFL1 may be aligned on the light-emitting elements LE and may be attached on the first semiconductor layers SEM1 of the light-emitting elements LE.

The first transfer film LFL1 may include a stretchable material. The stretchable material may include, for example, polyolefine, polyvinyl chloride (PVC), elastomeric silicone, elastomeric polyurethane, or elastomeric polyisoprene. The first transfer film LFL1, like the first support film SPF1, may include a support layer and an adhesive layer and may attach and support the light-emitting elements LE.

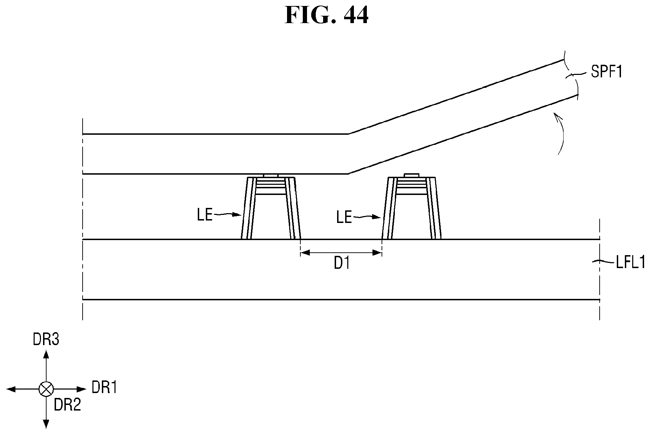

Thereafter, referring to FIG. 44, the first support film SPF1 may be separated from the light-emitting elements LE. The first support film SPF1 may be physically or naturally separated by applying UV light or heat to the first support film SPF1 to lower the adhesiveness of the adhesive layer of the first support film SPF1. The light-emitting elements LE may be a first distance D1 apart from one another on the first transfer film LFL1 and may be arranged as dots.

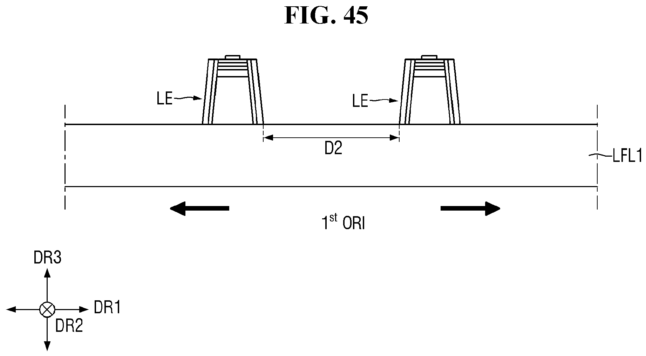

Thereafter, referring to FIG. 45, the first transfer film LFL1 may be stretched ("1^{st} ORI"). The first transfer film LFL1 may be two-dimensionally stretched in both first and second directions DR1 and DR2. As the first transfer film LFL1 is stretched, the distance between the light-emitting elements LE attached on the first transfer film LFL1 may increase from the first distance D1 to a second distance D2, which is greater than the first distance D1. The stretching strength (or tensile strength) of the first transfer film LFL1 may be adjusted in accordance with the desired distance between the light-emitting elements LE and may be, for example, about 120 gf/inch, but embodiments are not limited thereto.

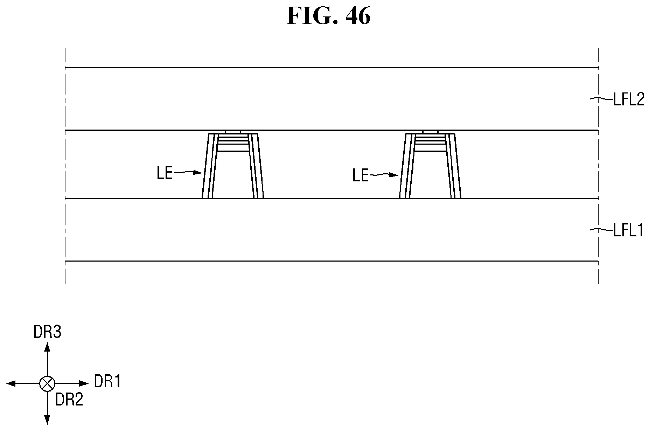

Thereafter, referring to FIG. 46, a second transfer film LFL2 may be attached on the light-emitting elements LE with the first support film SPF1 separated therefrom. The second transfer film LFL2 may be aligned on the light-emitting elements LE and may be attached on the connecting electrodes BOL of the light-emitting elements LE. The second transfer film LFL2, like the first transfer film LFL1, may include a support layer and an adhesive layer, and a detailed description of the second transfer film LFL2 will be omitted.

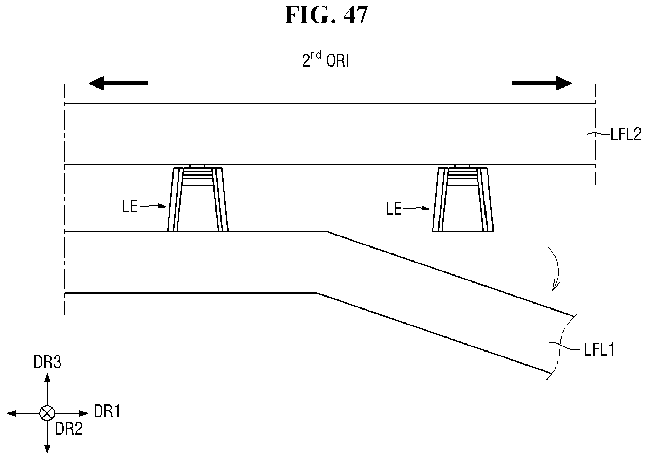

Thereafter, referring to FIG. 47, the first transfer film LFL1 may be separated from the light-emitting elements LE. The first transfer film LFL1 may be physically or naturally separated by applying UV light or heat to the first transfer film LFL1 to lower the adhesiveness of the adhesive layer of the transfer film LFL1.

Thereafter, the second transfer film LFL2 may be stretched ("2^{nd} ORI"). The second transfer film LFL2 may be two-dimensionally stretched in both the first and second directions DR1 and DR2. As the second transfer film LFL2 is stretched, the distance between the light-emitting elements LE attached on the second transfer film LFL2 may further increase. The stretching strength (or tensile strength) of the second transfer film LFL2 may be adjusted in accordance with the desired distance between the light-emitting elements LE and may be, for example, about 270 gf/inch, but embodiments are not limited thereto.

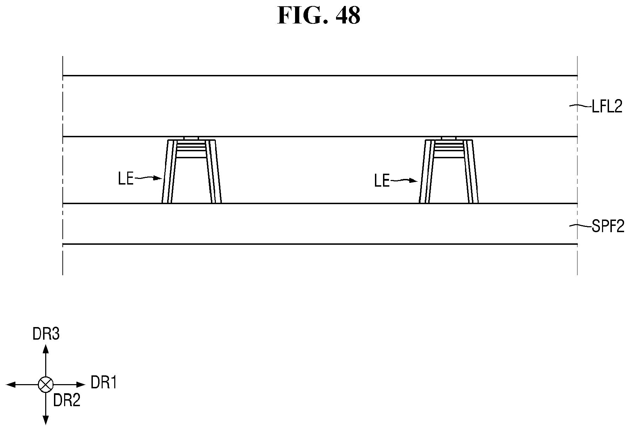

Thereafter, referring to FIG. 48, a second support film SPF2 may be attached on the light-emitting elements LE with the first transfer film LFL1 separated therefrom. The second support film SPF2 may be aligned on the light-emitting elements LE and may be attached on the first semiconductor layers SEM1 of the light-emitting elements LE. The second support film SPF2, like the first support film SPF1, may include a support layer and an adhesive layer, and a redundant description of the second support film SPF2 will be omitted for descriptive convenience.

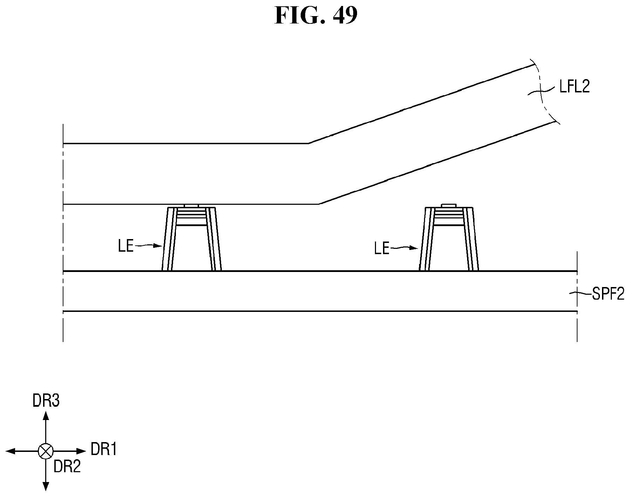

Thereafter, referring to FIG. 49, the second transfer film LFL2 may be separated. For example, the second transfer film LFL2 attached on the connecting electrodes BOL of the light-emitting elements LE may be separated. The separation of the second transfer film LFL2 may be the same as the separation of the first transfer film LFL1, and thus, a redundant description thereof will be omitted for descriptive convenience. The second transfer film LFL2 may be separated and removed from the connecting electrodes BOL of the light-emitting elements LE.

Two stretching processes may be performed, but embodiments are not limited thereto. In another example, more than two stretching processes may be performed.

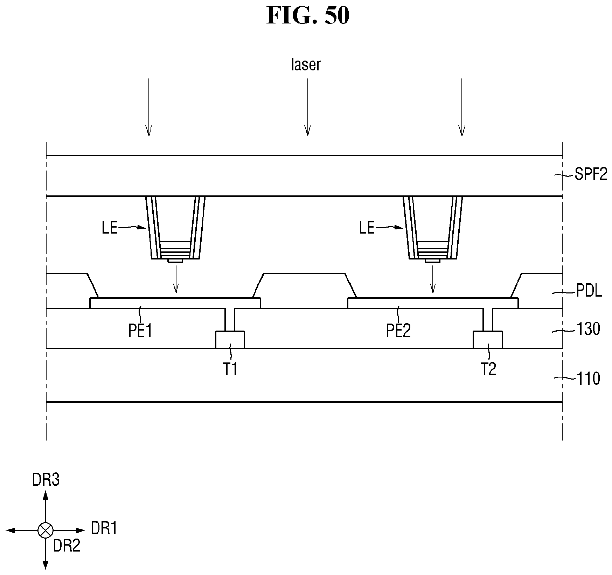

Thereafter, referring to FIG. 50, the second support film SPF2 may be bonded onto the substrate 110, and the light-emitting elements LE may be attached onto first and second pixel electrodes PE1 and PE2.

For example, the second support film SPF2 may be aligned on the substrate 110. The second support film SPF2 may be aligned such that the connecting electrodes BOL of the light-emitting elements LE on the second support film SPF2 may face the substrate 110.
The substrate 110 may have the first and second pixel electrodes PE1 and PE2 and a pixel-defining film PDL formed thereon, as illustrated in FIG. 6.

Thereafter, the substrate 110 and the second support film SPF2 may be bonded together. For example, the connecting electrodes BOL of the light-emitting elements LE on the second support film SPF2 may be placed in contact with the first and second pixel electrodes PE1 and PE2 of the substrate SUB. For example, the connecting electrodes BOL of the light-emitting elements LE may be in contact with the first and second pixel electrodes PE1 and PE2. Thereafter, the substrate 110 and the second support film SPF2 may be bonded together by fuse-bonding the connecting electrodes BOL of the light-emitting elements LE to the first and second pixel electrodes PE1 and PE2. The light-emitting elements LE may be attached on the top surfaces (or upper surfaces) of the first and second pixel electrodes PE1 and PE2.

The fuse-bonding of the connecting electrodes BOL of the light-emitting elements LE to the first and second pixel electrodes PE1 and PE2 may be performed by applying laser light to the first and second pixel electrodes PE1 and PE2 from above the second support film SPF2. For example, heat from the laser light may be conducted in the first and second pixel electrodes PE1 and PE2 so that the interfaces between the connecting electrodes BOL of the light-emitting elements LE and the first and second pixel electrodes PE1 and PE2 may be bonded. As the first and second pixel electrodes PE1 and PE2 include Cu, which has excellent thermal conductivity, the first and second pixel electrodes PE1 and PE2 may have excellent adhesiveness to the connecting electrodes BOL of the light-emitting elements LE. Yttrium-aluminum-garnet (YAG) laser may be used to fuse-bond the connecting electrodes BOL of the light-emitting elements LE to the first and second pixel electrodes PE1 and PE2.

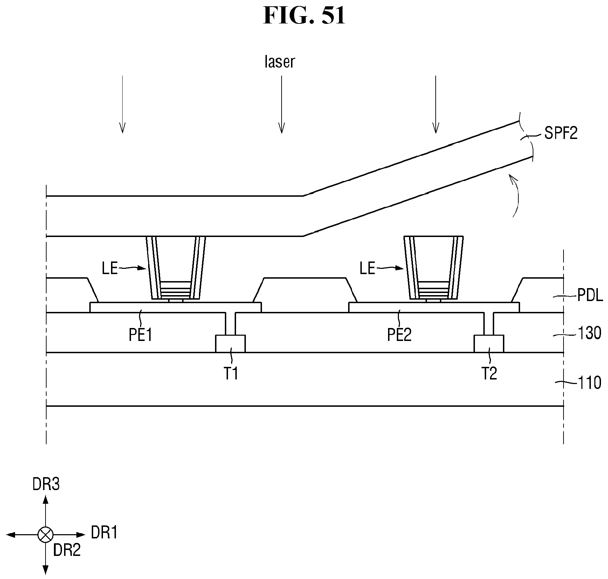

Thereafter, referring to FIG. 51, the second support film SPF2 may be separated from the light-emitting elements LE.

For example, the second support film SPF2 may be separated from the first semiconductor layers SEM1 of the light-emitting elements LE. The separation of the second support film SPF2 may be performed by laser liftoff (LLO) process. The laser liftoff (LLO) process, which is a process by using laser light, may use KrF excimer laser having a wavelength of about 248 nm as a source. Excimer laser light may be applied to an incident area of about 50×50 µm² to about 1×1 cm² at an energy density of about 550 mJ/cm² to about 950 mJ/cm², but embodiments are not limited thereto. As laser light is applied to the second support film SPF2, the second support film SPF2 may be separated from the light-emitting elements LE.

In another example, the second support film SPF2 may be physically separated. As the adhesion between the second support film SPF2 and the light-emitting elements LE is weaker than the adhesion between the connecting electrodes BOL of the light-emitting elements LE and the first and second pixel electrodes PE1 and PE2, the second support film SPF2 may be physically separated.

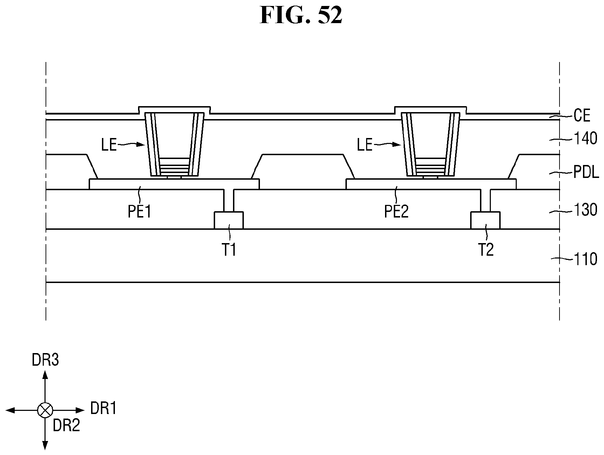

Thereafter, referring to FIG. 52, an organic layer 140 may be formed on the substrate 110 where the light-emitting elements LE are formed. The organic layer 140 may be formed on the first and second pixel electrodes PE1 and PE2 and the pixel-defining film PDL. The organic layer 140 may be disposed in each of the first and second emission areas EA1 and EA2 such that the first and second emission areas EA1 and EA2 may be separated (or spaced apart) from each other. The organic layer 140 may be formed by being applied via a solution process (e.g., spin coating or inkjet printing) and being patterned via an exposure process. The organic layer 140 may be higher than the first semiconductor layers SEM1 of the light-emitting elements LE, but embodiments are not limited thereto.

Thereafter, a common electrode CE may be formed on the light-emitting elements LE and the organic layer 140. The common electrode CE may be formed continuously over an entire display area. The common electrode CE may cover the organic layer 140 and the light-emitting elements LE and may be in contact with (e.g., in direct contact with the organic layer 140 and the light-emitting elements LE. The common electrode CE may be in contact with (e.g., in direct contact with) the top surfaces (or upper surfaces) of the first semiconductor layers SEM1 of the light-emitting elements LE.

Thereafter, as illustrated in FIG. 6, a wavelength control layer, a color filter layer, and the like may be formed, thereby implementing the display device 10.

As discussed, embodiments may provide a light-emitting element comprising: a first semiconductor layer; a light-emitting layer disposed on the first semiconductor layer; a second semiconductor layer disposed on the light-emitting layer; a device electrode layer disposed on the second semiconductor layer; a reflective electrode layer disposed on the device electrode layer; an insulating film surrounding a side surface of the light-emitting layer, a side surface of the second semiconductor layer, and a side surface of the device electrode layer; and a reflective layer surrounding a side surface of the insulating film, wherein the side surface of the device electrode layer is aligned with a side surface of the reflective electrode layer.

An upper surface of the device electrode layer may aligned with an upper surface of the insulating film and an upper surface of the reflective layer.

The insulating film may surround a side surface of the first semiconductor layer.

The light-emitting element may a particulate device. The light-emitting element may have a rod or cylindrical shape with a predetermined aspect ratio.

The light-emitting element may have two ends (e.g. in an extension direction of the light-emitting element), and a side surface of light-emitting element may extend from one end to another. The upper surfaces of the layers of the light-emitting element may face one end (e.g. an upper end).

The light-emitting element may be used in the manufacture of a display device. During manufacture, the light-emitting element may be attached onto a pixel electrode of the display device.

For example, a first transfer film may be attached on the first semiconductor layer of the light-emitting element. The first transfer film may be aligned on the light-emitting elements and may be attached on the first semiconductor layers of the light-emitting elements. The first transfer film may include a stretchable material.

Embodiments may provide a light-emitting element comprising: a first semiconductor layer; a light-emitting layer disposed on the first semiconductor layer; a second semiconductor layer disposed on the light-emitting layer; a device electrode layer disposed on the second semiconductor layer; an insulating film surrounding a side surface of the light-emitting layer, a side surface of the second semiconductor layer, and a side surface of the device electrode layer; and an insulating film surrounding a side surface of the light-emitting layer, a side surface of the second semiconductor layer, and a side surface of the device electrode layer, wherein the first semiconductor layer includes: a first portion spaced apart from the light-emitting layer, and a second portion surrounded by the insulating film and adjacent to the light-emitting layer, and a width of the second portion of the first semiconductor layer is less than a width of the first portion of the first semiconductor layer.

The length of the second portion of the first semiconductor layer may be less than a length of the first portion of the first semiconductor layer.

The light-emitting element may have two ends (e.g. in an extension direction of the light-emitting element), and a side surface of light-emitting element may extend from one end to another. The upper surfaces of the layers of the light-emitting element may face one end (e.g. an upper end).

The light-emitting element may be used in the manufacture of a display device. During manufacture, the light-emitting element may be attached onto a pixel electrode.

The side surface of the light-emitting element may be inclined with respect of the ends of the light-emitting element.

The side surface of the light-emitting element may form an angle of 90 degrees or less with the bottom surface (or lower surface) of the light-emitting element.

Embodiments may provide a display device comprising: a substrate; pixel electrodes disposed on the substrate; light-emitting elements disposed on the pixel electrodes; an organic layer disposed on the pixel electrodes and disposed between the light-emitting elements; and a common electrode disposed on the organic layer and the light-emitting elements, wherein each of the light-emitting elements may be according to any of the herein discussed embodiments.

In concluding the detailed description, those skilled in the art will appreciate that many variations and modifications may be made to the embodiments without substantially departing from the principles of the invention. Therefore, the disclosed embodiments of the invention are used in a generic and descriptive sense only and not for purposes of limitation.

## Claims

1. A light-emitting element comprising:
a first semiconductor layer;
a light-emitting layer disposed on the first semiconductor layer;
a second semiconductor layer disposed on the light-emitting layer;
a device electrode layer disposed on the second semiconductor layer;
a reflective electrode layer disposed on the device electrode layer;
an insulating film surrounding a side surface of the light-emitting layer, a side surface of the second semiconductor layer, and a side surface of the device electrode layer; and
a reflective layer surrounding a side surface of the insulating film,
wherein the side surface of the device electrode layer is aligned with a side surface of the reflective electrode layer.

2. The light-emitting element of claim 1, wherein an upper surface of the device electrode layer is aligned with an upper surface of the insulating film and an upper surface of the reflective layer.

3. The light-emitting element of claim 1 or 2, wherein
the insulating film further surrounds a side surface of the reflective electrode layer, and
an upper surface of the reflective electrode layer is aligned with an upper surface of the insulating film and an upper surface of the reflective layer.

4. The light-emitting element of any one of claims 1 to 3, wherein
the insulating film further surrounds a side surface of the reflective electrode layer, and
a lower surface of the first semiconductor layer is aligned with a lower surface of the insulating film and a lower surface of the reflective layer.

5. The light-emitting element of any one of claims 1 to 4, wherein the insulating film is formed as a multilayer film.

6. The light-emitting element of any one of claims 1 to 5, wherein
the reflective layer includes first layers and second layers, which include an insulating material having a different refractive index, and
the first layers and the second layers are alternately arranged.

7. The light-emitting element of any one of claims 1 to 6, wherein the reflective layer is formed as a single-layer film or a multilayer film including a metal.

8. A light-emitting element comprising:
a first semiconductor layer;
a light-emitting layer disposed on the first semiconductor layer;
a second semiconductor layer disposed on the light-emitting layer;
a device electrode layer disposed on the second semiconductor layer;
an insulating film surrounding a side surface of the first semiconductor layer, a side surface of the light-emitting layer, a side surface of the second semiconductor layer, and a side surface of the device electrode layer;, wherein
the first semiconductor layer includes:
a first portion spaced apart from the light-emitting layer, and
a second portion surrounded by the insulating film and adjacent to the light-emitting layer, and
a width of the second portion of the first semiconductor layer is less than a width of the first portion of the first semiconductor layer.

9. The light-emitting element of claim 8, wherein a width of the light-emitting layer, a width of the second semiconductor layer, and a width of the device electrode layer are less than the width of the first portion of the first semiconductor layer.

10. The light-emitting element of claim 8 or 9, wherein a side surface of the insulating film is aligned with a side surface of the first portion of the first semiconductor layer.

11. The light-emitting element of any one of claims 8 to 10, further comprising:
a reflective layer surrounding a side surface of the insulating film,
wherein a side surface of the reflective layer is aligned with a side surface of the first portion of the first semiconductor layer;
optionally further comprising: a metal layer surrounding the side surface of the insulating film and a side surfaces of the first portion of the first semiconductor layer.

12. The light-emitting element of any one of claims 8 to 11, further comprising:
a metal layer surrounding the side surface of the first portion of the first semiconductor layer;
optionally wherein the metal layer further surrounds a side surface of the insulating film.

13. The light-emitting element of any one of claims 8 to 12, wherein the insulating film covers a portion of an upper surface of the device electrode layer.

14. The light-emitting element of claim 13, further comprising:
a reflective layer surrounding a side surface of the insulating film,
wherein the reflective layer overlaps an upper surface of the device electrode layer in a thickness direction.

15. The light-emitting element of claim 13, further comprising:
a metal layer surrounding a side surface of the first portion of the first semiconductor layer,
wherein the metal layer is not in contact with a side surface of the insulating film;
optionally further comprising: a reflective layer surrounding the side surface of the insulating film, wherein the side surface of the reflective layer is aligned with the side surface of the first portion of the first semiconductor layer.

16. The light-emitting element of claim 13, further comprising:
a metal layer disposed on the insulating film and the device electrode layer,
wherein the metal layer surrounds the side surface of the light-emitting layer and is disposed on an outer side surface of the insulating film;
optionally further comprising: a reflective layer disposed between the insulating film and the metal layer, wherein the reflective layer surrounds a side surface of the insulating film, and the metal layer surrounds the side surface of the light-emitting layer and is disposed on the outer side surface of the reflective layer.

17. The light-emitting element of any one of claims 8 to 16, further comprising:
a reflective layer surrounding a side surface of the insulating film and a side surface of the second portion of the first semiconductor layer,
wherein the reflective layer is a distributed Bragg reflector, DBR.

18. A display device comprising:
a substrate;
pixel electrodes disposed on the substrate;
light-emitting elements disposed on the pixel electrodes;
an organic layer disposed on the pixel electrodes and disposed between the light-emitting elements; and
a common electrode disposed on the organic layer and the light-emitting elements, wherein
each of the light-emitting elements is according to any one of claims 1 to 17.

19. The display device of claim 18, wherein
each of the light-emitting elements further includes a connecting electrode disposed on the reflective electrode layer,
the connecting electrode of each light-emitting element is connected to one of the pixel electrodes, and
the first semiconductor layer of each light-emitting element is connected to the common electrode.

20. The display device of claim 19, further comprising:
a second insulating film surrounding an outer surface of the reflective layer of each light-emitting element,
wherein the reflective layer includes a metal.

21. The display device of claim 20, wherein the second insulating film of each light-emitting element is in contact with the corresponding pixel electrode and connecting electrode.

22. The display device of claim 20 or 21, further comprising:
a third insulating film disposed between the reflective layer of each light-emitting element and the common electrode,
wherein the third insulating film is in contact with the reflective layer and covers the reflective layer.

23. The display device of any one of claims 20 to 22, wherein
the second insulating film of each light-emitting element is in contact with one of the pixel electrodes, and
a gap is disposed between the connecting electrode and the second insulating film.

24. The display device of any one of claims 18 to 23, wherein
the organic layer includes:
a first organic layer disposed on the pixel electrodes, and
a second organic layer disposed on the first organic layer, and
the reflective layer of each light-emitting element is disposed on the first organic layer, surrounds the side surface of the light-emitting layer, and is disposed on an outer side surface of the first insulating film.

25. The display device of any one of claims 18 to 24, wherein
the common electrode surrounds the side surface of the first insulating film of each light-emitting element and is in contact with the side surface of the first insulating film.
